# EUROPEAN PATENT APPLICATION

(11) **EP 4 425 536 A1**
(43) Date of publication of application: **04.09.2024**
(21) Application number: 21964361.6
(22) Date of filing: 18.11.2021
(51) Int. Cl.: H01L 21/336, H10B 12/00

(54) **SEMICONDUCTOR STRUCTURE AND PREPARATION METHOD THEREFOR, AND RADIO FREQUENCY CIRCUIT AND COMMUNICATION DEVICE**

(71) Applicant: Huawei Technologies Co., Ltd., Shenzhen, Guangdong 518129 (CN)
(72) Inventor: XU, Xiangming, Shenzhen, Guangdong 518129 (CN); JIAN, Zhongxiang, Shenzhen, Guangdong 518129 (CN); WANG, Xiaohong, Shenzhen, Guangdong 518129 (CN)
(74) Representative: Gill Jennings & Every LLP
(86) International application number: PCT/CN2021/131423
(87) International publication number: WO 2023/087201

(57) **Abstract**

Embodiments of this application relate to the field of semiconductor technologies, and provide a semiconductor structure, a preparation method thereof, a radio frequency circuit, and a communication apparatus, to prepare a semiconductor structure with high performance. The semiconductor structure may be, for example, an HBT device. The semiconductor structure includes a substrate, and an intrinsic base region, an extrinsic base region, and an emitter region that are disposed on the substrate. The substrate includes a collector region, a first isolation structure, and an auxiliary extrinsic base region that are buried in the substrate. The substrate includes a collector region, a first isolation structure, and an auxiliary extrinsic base region that are buried in the substrate. The collector region is disposed under the intrinsic base region. The auxiliary extrinsic base region is disposed under the extrinsic base region. The first isolation structure wraps a side surface and a bottom surface of the auxiliary extrinsic base region, and is in contact with the side surface and the bottom surface of the auxiliary extrinsic base region. Parts that are of first isolation structures, that are located in auxiliary extrinsic base regions, and that are close to the collector region have equal thickness.

## Description

### TECHNICAL FIELD

This application relates to the field of semiconductor technologies, and in particular, to a semiconductor structure and a preparation method thereof, a radio frequency circuit, and a communication apparatus.

### BACKGROUND

Because modem communication requires a high-performance, low-noise, and cost-effective radio frequency (Radio Frequency, RF) component in a high frequency band, a semiconductor structure with a higher and wider frequency band plays an increasingly important role. A highly integrated semiconductor structure with good thermal conductivity, good substrate mechanical performance, and good linearity becomes a trend of future development.

However, a technical challenge currently lies in how to complete processing of the semiconductor structure by using a simple process, to reduce process costs. In addition, it is also important to increase a maximum oscillation frequency of a device.

### SUMMARY

Embodiments of this application provide a semiconductor structure, a preparation method thereof, a radio frequency circuit, and a communication apparatus, to prepare a semiconductor structure with high performance.

To achieve the foregoing objective, this application uses the following technical solutions.

According to a first aspect, an embodiment of this application provides a semiconductor structure. For example, the semiconductor structure may be understood as a heterojunction bipolar transistor HBT, or a structure in which a complementary metal-oxide semiconductor CMOS and an HBT are integrated. The semiconductor structure includes a substrate, and an intrinsic base region, an extrinsic base region, and an emitter region that are disposed on the substrate. The substrate includes a collector region, a first isolation structure, and an auxiliary extrinsic base region that are buried in the substrate. The collector region is disposed under the intrinsic base region, for example, the collector region is in contact with the intrinsic base region on a surface of the substrate. The auxiliary extrinsic base region is disposed under the extrinsic base region, for example, the auxiliary extrinsic base region is in contact with the extrinsic base region on the surface of the substrate. The first isolation structure wraps a side surface and a bottom surface of the auxiliary extrinsic base region, for example, the first isolation structure is in contact with the side surface and the bottom surface of the auxiliary extrinsic base region. Parts that are of first isolation structures, that are located in auxiliary extrinsic base regions, and that are close to the collector region have equal thickness.

According to the semiconductor structure provided in this embodiment of this application, the substrate of the semiconductor structure includes the first isolation structure, and the parts that are of the first isolation structures, that are located in the auxiliary extrinsic base regions, and that are close to the collector region (between the collector region and the auxiliary extrinsic base region) have equal thickness. Therefore, according to the formula C=εS/d (ε is a dielectric constant, S is an area in which plates are directly opposite to each other, and d is a distance between the plates) of parasitic capacitance, it can be learned that when materials (which affect ε) of the first isolation structures on both sides of the collector region and an area (which affects S) in which the auxiliary extrinsic base region and the collector region are directly opposite to each other are fixed, the parts that are of the first isolation structures, that are located in the auxiliary extrinsic base regions, and that are close to the collector region have equal thickness (which affects d). This can improve symmetry of parasitic collector-base junction capacitance on both sides of a central line. Therefore, a radio frequency current can be evenly distributed on both sides of the central line, and device performance (for example, a maximum oscillation frequency) is optimal. In addition, both an intrinsic base region and an extrinsic base region are disposed on the surface of the substrate, the collector region is disposed inside the substrate, and there is no raised epitaxial collector region. Therefore, the intrinsic base region and the extrinsic base region are directly formed on the surface of the known substrate, and whether the intrinsic base region is in contact with the extrinsic base region is directly controlled by preparation processes of the intrinsic base region and the extrinsic base region. In comparison with the intrinsic base region disposed on the epitaxial collector region that is disposed on the surface of the substrate, the intrinsic base region and the extrinsic base region are directly disposed on the surface of the substrate in this embodiment of this application. In this case, contact between the intrinsic base region and the extrinsic base region is not affected due to a parameter like thickness of the raised epitaxial collector region. This can improve a contact yield between the intrinsic base region and the extrinsic base region, and further improve a yield of the semiconductor structure. In addition, impact of the thickness of the collector region on effect of the contact between the intrinsic base region and the extrinsic base region does not need to be considered. Therefore, this can reduce a requirement for process accuracy of manufacturing the collector region, and reduce a process difficulty. In addition, the collector region is obtained through doping, and an epitaxy growth process (for preparing the collector region) is not needed, to save processing costs. In addition, the auxiliary extrinsic base region is buried in the substrate in advance, and after the auxiliary extrinsic base region is in contact with the extrinsic base region, thickening of the extrinsic base region is implemented, to reduce resistance of the extrinsic base region.

In a possible implementation, thickness of the first isolation structure is the same at all positions. The same thickness of the first isolation structure at all positions may be implemented by forming a film and patterning. When a process error is not considered, film thickness of a finally formed first isolation structure is the same at all positions. Due to a process factor, there may be a deviation of several nanometers. In other words, thickness of the final parts that are located in the auxiliary extrinsic base regions and that are close to the collector region may have a deviation of several nanometers at most. However, in the photoetching and etching processes, thickness of the final parts that are located in the auxiliary extrinsic base regions and that are close to the collector region may have a deviation of dozens of nanometers. Therefore, the film thickness of the first isolation structure is set to be the same at all positions, so that the first isolation structure may be prepared by using a simple process with high precision. This ensures symmetry of the parasitic collector-base junction capacitance on both sides of the central line.

In a possible implementation, the substrate further includes a second isolation structure, the second isolation structure is located under the first isolation structure, and is in contact with the first isolation structure. The second isolation structure is disposed under the first isolation structure, to change a dielectric constant between the auxiliary extrinsic base region and a buried collector region. This can reduce parasitic capacitance of the collector region and the extrinsic base region, and improve device performance.

In a possible implementation, a projection of the first isolation structure on the substrate covers a projection of the second isolation structure on the substrate. Both the first isolation structure and the second isolation structure are formed by filling a groove with a dielectric material. The first isolation structure covers the second isolation structure, that is, a groove for placing the second isolation structure is smaller than a groove for placing the first isolation structure. In this case, the small groove is formed first, and then the large groove is formed. Therefore, a process has a low difficulty, and is easy to implementation.

In a possible implementation, the extrinsic base region includes a baselink region and an effective extrinsic base region, the baselink region is in contact with both the intrinsic base region and the effective extrinsic base region, a material of the baselink region includes quasi-single-crystalline silicon, and a material of the effective extrinsic base region includes polycrystalline silicon. In this way, the effective extrinsic base region is in contact with the baselink region, and the baselink region is in contact with the intrinsic base region, to realize contact between the extrinsic base region and the intrinsic base region. The material of the baselink region is quasi-single-crystalline silicon, and an activation rate of a doped ion of the baselink region is greater than that of a doped ion of the effective extrinsic base region (the material is polycrystalline silicon). Therefore, contact between the effective extrinsic base region and the intrinsic base region is implemented by using the baselink region, to reduce contact resistance between the extrinsic base region and the intrinsic base region.

In a possible implementation, the baselink region is linked to the intrinsic base region and/or the effective extrinsic base region. The baselink region is in contact with the intrinsic base region and the effective extrinsic base region in a linking manner, to reduce a requirement for process precision, and reduce a process difficulty.

In a possible implementation, the semiconductor structure further includes an auxiliary layer, the auxiliary layer is disposed between the extrinsic base region and the emitter region, and the emitter region is in contact with the intrinsic base region through an opening at the auxiliary layer. The auxiliary layer is disposed in the semiconductor structure, to isolate the extrinsic base region from the emitter region by using the auxiliary layer.

In a possible implementation, the semiconductor structure further includes an inner side wall, and the inner side wall is disposed between the extrinsic base region and the emitter region. The inner side wall is disposed in the semiconductor structure, to isolate the extrinsic base region from the emitter region by using the inner side wall.

In a possible implementation, the semiconductor structure further includes an outer side wall, and the outer side wall wraps a side surface of the emitter region, to protect the emitter region. The outer side wall can protect the emitter region during preparation of the semiconductor structure, to prevent another epitaxy growth step from affecting the emitter region.

In a possible implementation, the semiconductor structure further includes a cap layer, and the cap layer is disposed on the emitter region, to protect the emitter region. The cap layer can protect the emitter region during preparation of the semiconductor structure, to prevent another epitaxy growth step from affecting the emitter region.

In a possible implementation, the semiconductor structure further includes an emitter electrode, a base electrode, and a collector electrode disposed on the substrate. The emitter electrode is in contact with the emitter region, the base electrode is in contact with the extrinsic base region, and the collector electrode is in contact with the collector region.

In a possible implementation, the substrate further includes a sinker region and the buried collector region, the sinker region and the first isolation structure are located above the buried collector region, the sinker region is located on a side that is of the first isolation structure and that is away from the collector region, and both the sinker region and the collector region are in contact with the buried collector region. The collector electrode is in contact with the collector region through a connection hole that is in contact with the sinker region, the emitter electrode is in contact with the emitter region through a connection hole that passes through the cap layer and is in contact with the emitter region, and the base electrode is in contact with the extrinsic base region through a connection hole that is in contact with the extrinsic base region.

In a possible implementation, the substrate further includes a third isolation structure, and the third isolation structure is disposed outside the first isolation structure. The semiconductor structure further includes a complementary metal-oxide-semiconductor field-effect transistor, and the complementary metal-oxide-semiconductor field-effect transistor is disposed on the substrate, and is located on a side that is of the third isolation structure and that is away from the first isolation structure. In this way, the semiconductor structure is a CMOS+SiGe HBT device, and the CMOS and the SiGe HBT may be integrated on a same semiconductor structure, so that the semiconductor structure has advantages of the CMOS and the SiGe HBT.

According to a second aspect, an embodiment of this application provides a radio frequency circuit, including a transistor circuit that includes the semiconductor structure in any implementation of the first aspect.

The radio frequency circuit provided in this embodiment of this application includes the semiconductor structure in any implementation of the first aspect. Beneficial effect of the radio frequency circuit is the same as beneficial effect of the semiconductor structure. Details are not described herein again.

According to a third aspect, an embodiment of this application provides a communication apparatus, including a processor and the radio frequency circuit in the second aspect. The processor is configured to transmit a signal to the radio frequency circuit.

The radio frequency circuit included in the communication apparatus provided in this embodiment of this application includes the semiconductor structure in any implementation of the first aspect. Beneficial effect of the radio frequency circuit is the same as beneficial effect of the semiconductor structure. Details are not described herein again.

According to a fourth aspect, an embodiment of this application provides a preparation method for a semiconductor structure. The method includes: forming a groove on a base including an active region, where the groove is located under a to-be-formed extrinsic base region; sequentially forming an isolation film and an auxiliary extrinsic base region film on the base on which the groove is formed, and patterning the isolation film and the auxiliary extrinsic base region film, to form a first isolation structure and an auxiliary extrinsic base region that are located in the groove, where the first isolation structure wraps a side surface and a bottom surface of the auxiliary extrinsic base region; forming a first sacrificial film, a second sacrificial film, and an auxiliary film that are sequentially stacked on a surface of the base, and forming an emitter region window that passes through the auxiliary film and the second sacrificial film; forming a collector region in the base, to form a substrate of the semiconductor structure, where the collector region is located under the emitter region window; forming, on the first sacrificial film, an opening in communication with the emitter region window, and forming an intrinsic base region in the opening, where the intrinsic base region is in contact with the collector region on a surface of the substrate; forming an emitter region film on the auxiliary film, and patterning the emitter region film and the auxiliary film, to form an emitter region and an auxiliary layer, where the emitter region is in contact with the intrinsic base region through the emitter region window; and removing the first sacrificial film and the second sacrificial film, to form an extrinsic base region at a corresponding position, where the extrinsic base region is in contact with the auxiliary extrinsic base region on the surface of the substrate, and the extrinsic base region is further in contact with the intrinsic base region.

According to the preparation method for a semiconductor structure provided in this embodiment of this application, the groove is first formed on the base, and then the isolation film is formed in the groove. The isolation film is patterned, to prepare the first isolation structure. In this way, when a process error is not considered, film thickness of a finally formed first isolation structure is the same at all positions, to ensure that parts that are of first isolation structures, that are located in auxiliary extrinsic base regions, and that are close to the collector region have equal thickness. Due to a process factor, thickness of the parts that are of the first isolation structures, that are located in the auxiliary extrinsic base regions, and that are close to the collector region may have a deviation of several nanometers. However, in the photoetching and etching processes, thickness of the parts that are of the first isolation structures, that are located in the auxiliary extrinsic base regions, and that are close to the collector region may have a deviation of dozens of nanometers. Therefore, according to this embodiment of this application, it can be ensured that the parts that are of the first isolation structures, that are located in the auxiliary extrinsic base regions, and that are close to the collector region have equal thickness. Therefore, according to the formula C=εS/d (ε is a dielectric constant, S is an area in which plates are directly opposite to each other, and d is a distance between the plates) of parasitic capacitance, it can be learned that when materials (which affect ε) of the first isolation structures on both sides of the collector region and an area (which affects S) in which the auxiliary extrinsic base region and the collector region are directly opposite to each other are fixed, the parts that are of the first isolation structures, that are located in the auxiliary extrinsic base regions, and that are close to the collector region have equal thickness (which affects d). This can improve symmetry of parasitic collector-base junction capacitance on both sides of a central line. Therefore, a radio frequency current can be evenly distributed on both sides of the central line, and a maximum oscillation frequency of the semiconductor structure is optimal. In addition, in this embodiment of this application, preparation of each film layer may be implemented by using the conventional technology. The collector region 19 is also formed by defining a position by using a self-aligned structure and then performing ion implantation on the substrate.

In a possible implementation, the forming a groove on a base including an active region includes: forming the groove in the active region. The groove is directly formed in the active region under the to-be-formed extrinsic base region, a shallow trench isolation region does not need to be formed at the position.

In a possible implementation, the forming a groove on a base including an active region includes: forming the active region and a shallow trench isolation region on the base, where the shallow trench isolation region is located under the extrinsic base region; and removing a part of the shallow trench isolation region and a part of the active region at a periphery of the shallow trench isolation region, to form the groove, and using the shallow trench isolation region, under the groove, that is not removed as a second isolation structure of the semiconductor structure. The shallow trench isolation region is first formed under the to-be-formed extrinsic base region, then a part of the shallow trench isolation region and a part of the active region are removed, to form the groove, and the shallow trench isolation region that is not removed is used as the second isolation structure. The semiconductor structure obtained in the preparation manner includes the second isolation structure, and disposing the second isolation structure may change a dielectric constant between the auxiliary extrinsic base region and a buried collector region. This can reduce parasitic capacitance of the collector region and the extrinsic base region, and improve device performance. In addition, when the groove is formed, it is ensured that a part of the shallow trench isolation region close to the surface of the base is completely removed, to ensure that a periphery of the groove is the active region and does not include the shallow trench isolation region. This can prevent symmetry of parasitic collector-base junction capacitance from being affected by a remaining shallow trench isolation region.

In a possible implementation, the removing the first sacrificial film and the second sacrificial film, to form an extrinsic base region at a corresponding position includes: removing the second sacrificial film, to form a baselink region under the auxiliary layer, where the baselink region is in contact with the intrinsic base region; and removing the first sacrificial film, to form an effective extrinsic base region at a corresponding position, where the effective extrinsic base region is in contact with the baselink region. In this way, the effective extrinsic base region is in contact with the baselink region, and the baselink region is in contact with the intrinsic base region, to realize contact between the extrinsic base region and the intrinsic base region. A material of the baselink region is quasi-single-crystalline silicon, and an activation rate of a doped ion of the baselink region is greater than that of a doped ion of the effective extrinsic base region (a material is polycrystalline silicon). Therefore, contact between the effective extrinsic base region and the intrinsic base region is implemented by using the baselink region, to reduce contact resistance between the extrinsic base region and the intrinsic base region.

In a possible implementation, the preparation method further includes: forming a third isolation structure on the base, where the third isolation structure is located outside the first isolation structure; and forming a complementary metal-oxide-semiconductor field-effect transistor on the substrate, where the complementary metal-oxide-semiconductor field-effect transistor is located on a side that is of the third isolation structure and that is away from the first isolation structure. In this way, a CMOS and a SiGe HBT may be integrated on a same semiconductor structure, so that the semiconductor structure has advantages of the CMOS and the SiGe HBT.

### BRIEF DESCRIPTION OF DRAWINGS

FIG. 1A-1 and FIG. 1A-2 are a schematic diagram of a preparation process of a semiconductor structure according to an embodiment of this application;
FIG. 1B-1, FIG. 1B-2, and FIG. 1B-3 are a schematic diagram of a preparation process of another semiconductor structure according to an embodiment of this application;
FIG. 2A and FIG. 2B are a flowchart of preparing a semiconductor structure according to an embodiment of this application;
FIG. 3A-1, FIG. 3A-2, FIG. 3A-3, and FIG. 3A-4 to FIG. 3N are schematic diagrams of a preparation process of still another semiconductor structure according to an embodiment of this application;

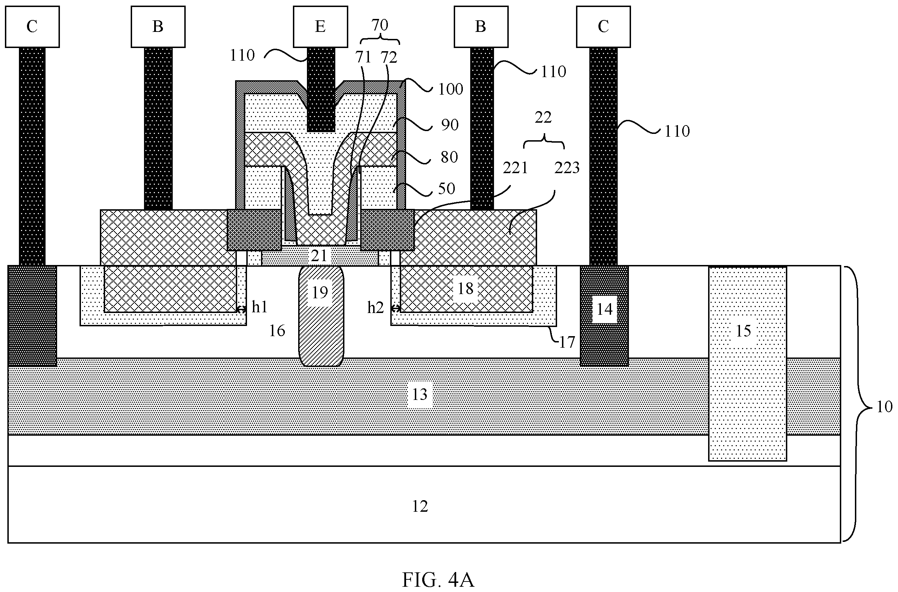

FIG. 4A is a schematic diagram of a structure of a semiconductor structure according to an embodiment of this application;

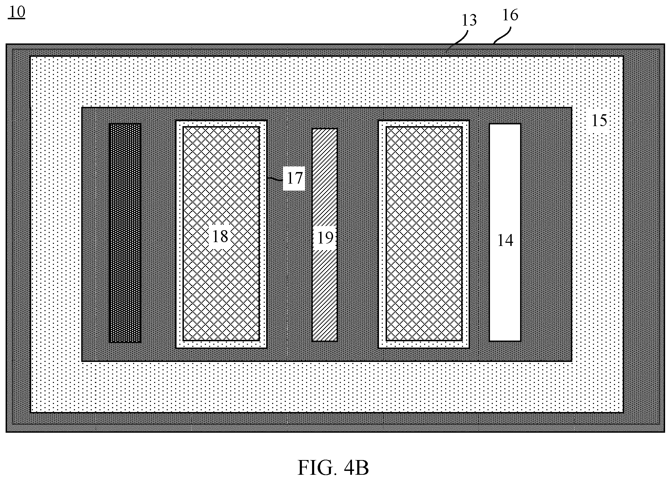

FIG. 4B is a top view of a substrate according to an embodiment of this application;

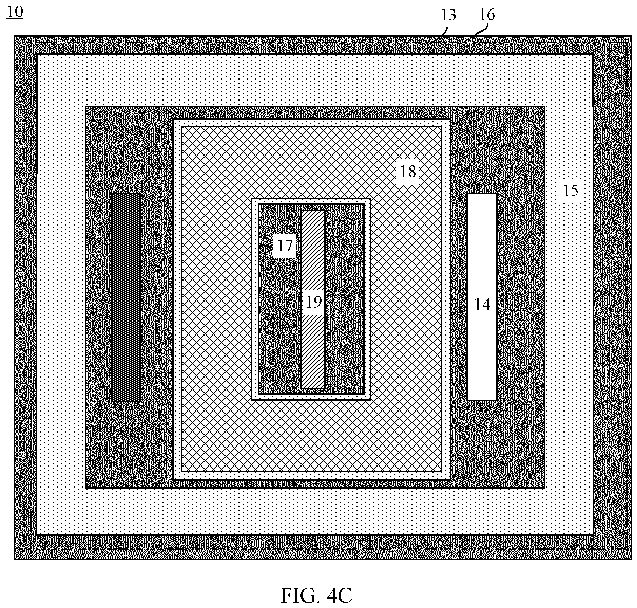

FIG. 4C is a top view of a substrate according to an embodiment of this application;

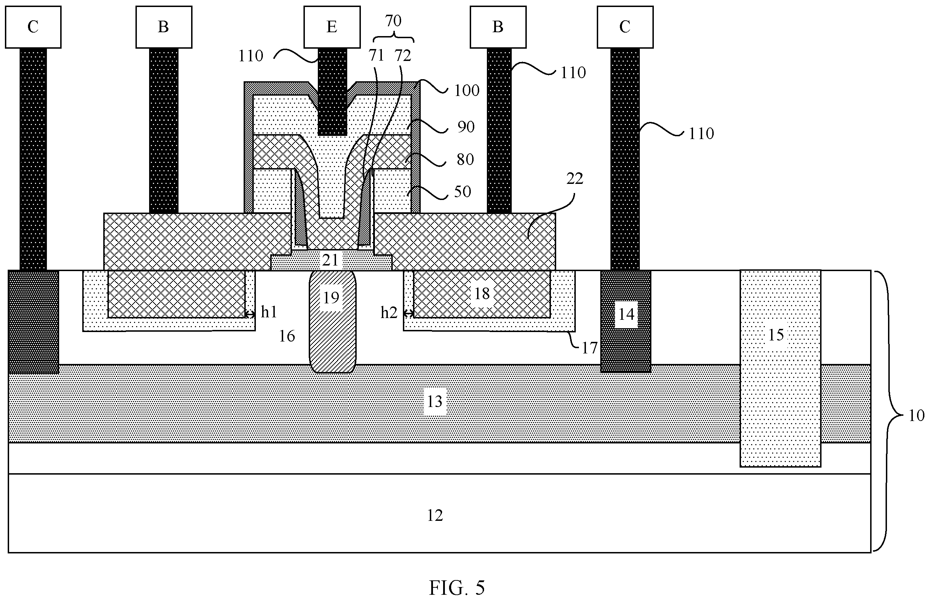

FIG. 5 is a schematic diagram of a structure of another semiconductor structure according to an embodiment of this application;

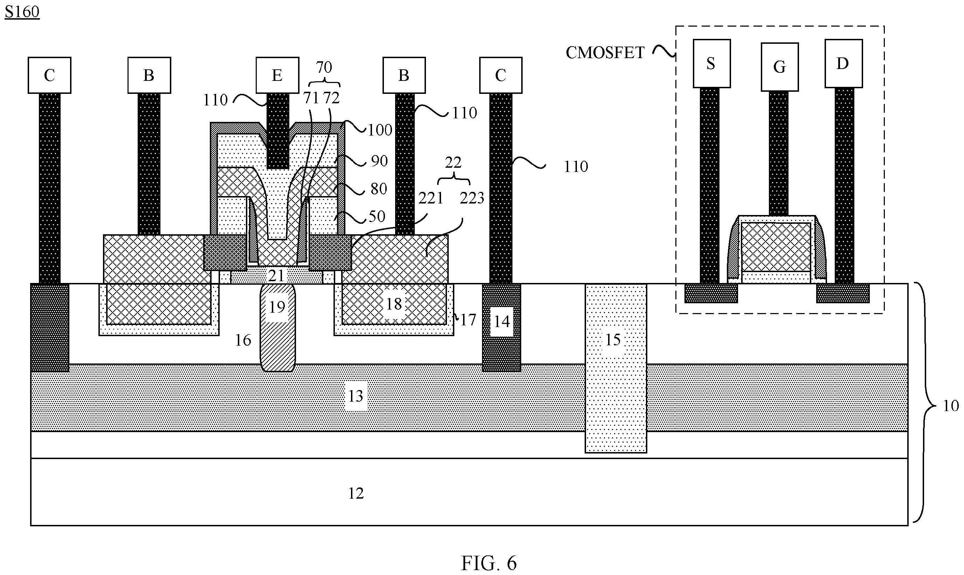

FIG. 6 is a schematic diagram of a structure of still another semiconductor structure according to an embodiment of this application;

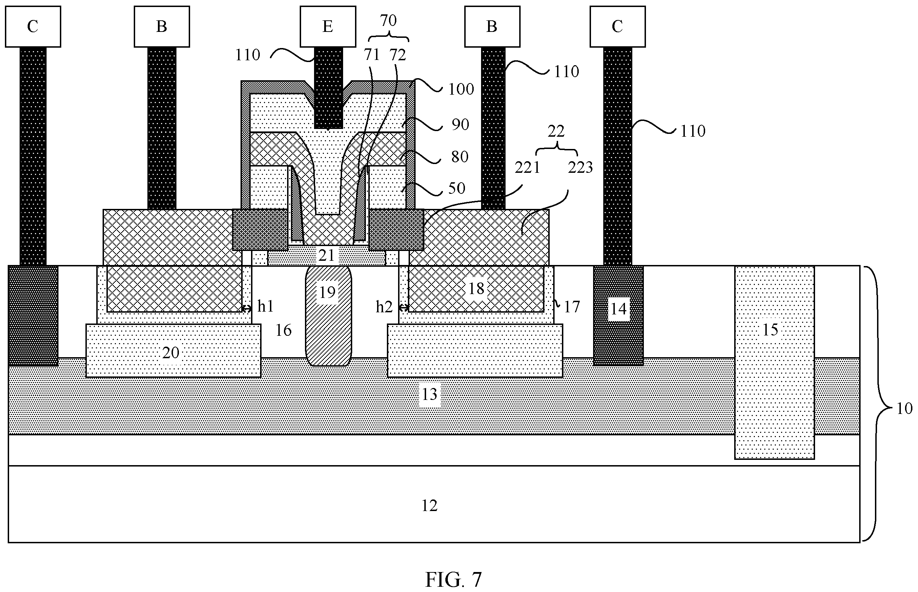

FIG. 7 is a schematic diagram of a structure of still another semiconductor structure according to an embodiment of this application;

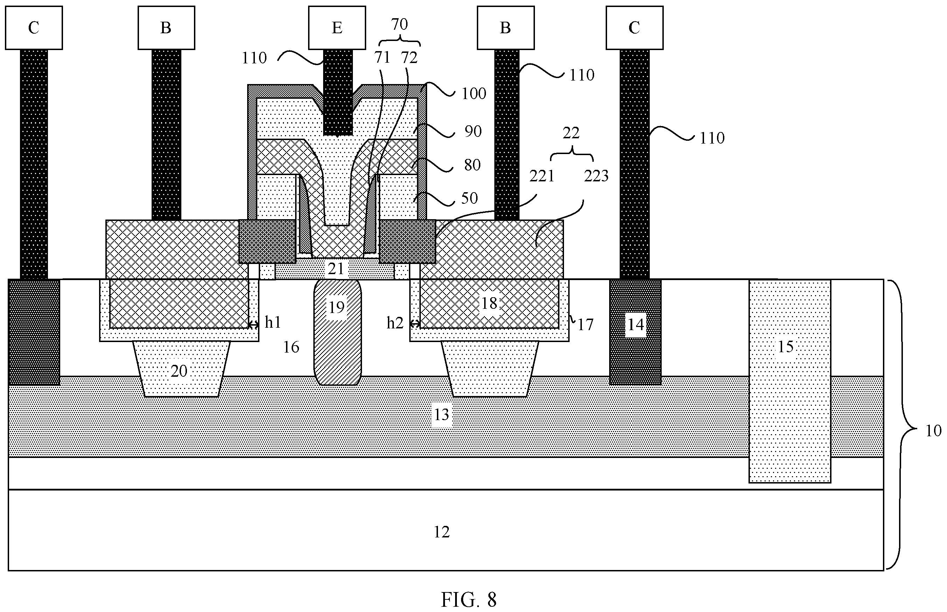

FIG. 8 is a schematic diagram of a structure of still another semiconductor structure according to an embodiment of this application;
FIG. 9A-1, FIG. 9A-2, and FIG. 9A-3 to FIG. 9D are schematic diagrams of a part of a preparation process of a semiconductor structure according to an embodiment of this application; and

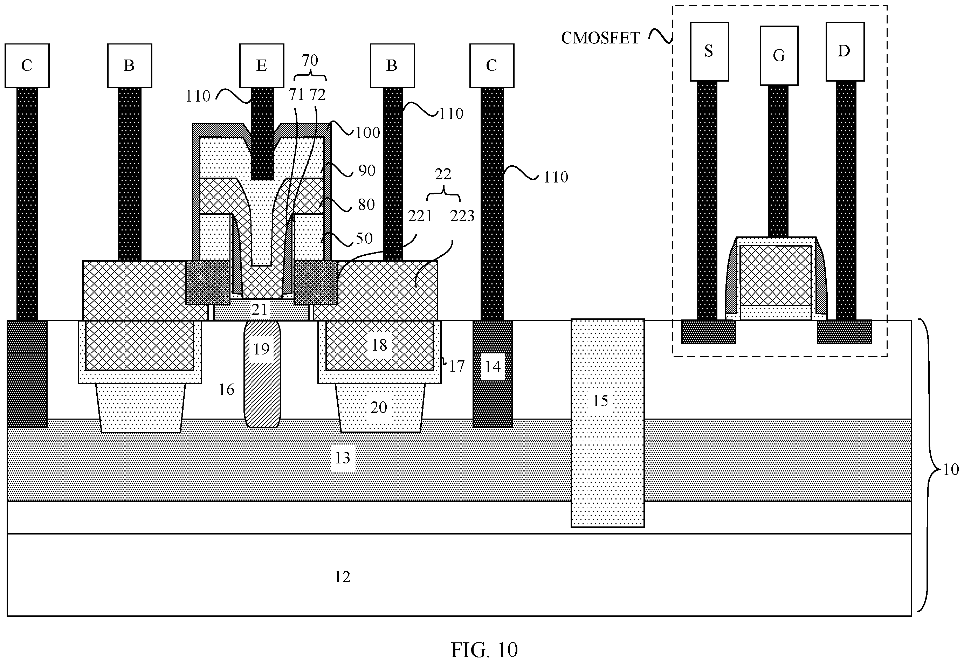

FIG. 10 is a schematic diagram of a structure of still another semiconductor structure according to an embodiment of this application.

### Reference numerals:

10: substrate; 11: base; 12: silicon substrate; 13: buried collector region; 14: sinker region; 15: third isolation structure; 16: active region; 17: first isolation structure; 18: auxiliary extrinsic base region; 19: collector region; 20: second isolation structure; 201: shallow trench isolation region; 21: intrinsic base region; 22: extrinsic base region; 221: baselink region; 222: extrinsic base region film; 223: effective extrinsic base region; 31: first sacrificial film; 32: first opening; 41: second sacrificial film; 42: second opening; 50: auxiliary layer; 51: auxiliary film; 52: third opening; 60: first inner side wall; 61: first dielectric film; 62: second dielectric film; 63: second inner wall body; 64: first inner wall body; 70: second inner side wall; 71: third inner wall body; 72: fourth inner wall body; 80: emitter region; 81: emitter region film; 90: cap layer; 91: cap film; 100: outer side wall; 101: third dielectric film; 102: fourth dielectric film; 103: first outer wall body; 104: second outer wall body; and 110: connection hole.

### DESCRIPTION OF EMBODIMENTS

The following describes technical solutions in embodiments of this application with reference to the accompanying drawings in embodiments of this application. It is clear that the described embodiments are merely a part rather than all of embodiments of this application.

Terms such as "first" and "second" mentioned below in embodiments of this application are merely used for ease of description, and shall not be understood as an indication or implication of relative importance or implicit indication of a quantity of indicated technical features. Therefore, features defined with "first", "second", and the like may explicitly or implicitly include one or more such features. In the descriptions of this application, unless otherwise stated, "a plurality of" means two or more than two.

In embodiments of this application, "up", "down", "left", and "right" are not limited to definitions relative to directions in which components are schematically placed in accompanying drawings. It should be understood that these directional terms may be relative concepts used for relative description and clarification, and may change correspondingly based on a change of a direction in which a component in an accompanying drawing is placed.

In embodiments of this application, unless otherwise specified in the context, in the entire specification and claims, the term "include" is interpreted as "open and inclusive", that is, "include, but not limited to". In the descriptions of the specification, terms such as "an embodiment", "some embodiments", "example embodiments", "examples", or "some examples" are intended to indicate that specific features, structures, materials, or features related to embodiments or examples are included in at least one embodiment or example of the present disclosure. The foregoing schematic representations of the terms do not necessarily refer to a same embodiment or example. Further, the particular feature, structure, material, or characteristic may be included in any one or more embodiments or examples in any appropriate manner.

When some embodiments are described, expressions of "coupling" and "connection" and their extensions may be used. For example, when some embodiments are described, the term "connection" may be used to indicate that two or more components are in direct physical contact or electrical contact with each other. For another example, when some embodiments are described, the term "coupling" may be used to indicate that two or more components are in direct physical contact or electrical contact. However, the term "coupling" may also indicate that two or more components do not directly contact each other, but still collaborate or interact with each other. Embodiments disclosed herein are not necessarily limited to content of this specification.

The term "and/or" in embodiments of this application describes only an association relationship for describing associated objects and represents that three relationships may exist. For example, A and/or B may represent the following three cases: Only A exists, both A and B exist, and only B exists. In addition, the character "/" in this specification usually indicates an "or" relationship between the associated objects.

In embodiments of this application, an example implementation is described with reference to a sectional view and/or a plane diagram and/or an equivalent circuit diagram that are/is used as idealized example accompanying drawings. In the accompanying drawings, for clarity, thickness of layers and regions is increased. Therefore, a change in a shape in the accompanying drawings due to, for example, manufacturing techniques and/or tolerances may be envisaged. Therefore, example implementations should not be construed as being limited to a shape of a region shown herein, but rather include shape deviations due to, for example, manufacturing. For example, an etching region shown as a rectangle typically has a bending characteristic. Therefore, the regions shown in the accompanying drawings are essentially examples, and their shapes are not intended to show actual shapes of regions of a device, and are not intended to limit a scope of the example implementations.

A conventional process of a silicon-based complementary metal-oxide semiconductor (complementary metal-oxide semiconductor, CMOS) has low costs, and a CMOS device can implement a high frequency response by using advanced process nodes, and is suitable for high-frequency application. However, for devices with a same frequency response, the CMOS device has a lower breakdown voltage, while a silicon-germanium heterojunction bipolar transistor (SiGe heterojunction bipolar transistor, SiGe HBT) has a higher breakdown voltage, and is suitable for application with higher output power. In addition, the SiGe HBT has higher transconductance than the CMOS device. Based on simulation prediction of a latest semiconductor simulation tool (Technology Computer Aided Design, TCAD), a current gain cut-off frequency limit of a SiGe HBT device is 1 THz, and a power gain cut-off frequency limit is 2 THz. In this case, the SiGe HBT device can meet high-frequency and high-speed application requirements for a long time. Moreover, electron and hole mobility of an III-V group material like GaAs (gallium arsenide) and InP (indium phosphate) is much higher than that of silicon, and the III-V group material has an excellent high-frequency characteristic. In addition, because of a high forbidden band width, the III-V group material has a higher breakdown voltage than that of the SiGe HBT, and is also suitable for high-frequency and high-power application. However, the III-V material has disadvantages such as high costs, high environmental protection costs, poor heat conduction, and poor mechanical performance.

The CMOS and the SiGe HBT are integrated on a same chip (CMOS+SiGe, SiGe BiCMOS). The SiGe HBT has advantages such as a high frequency, a high speed, high gain, and low noise, and is suitable for an analog circuit design. The CMOS has an advantage of low power consumption, and is suitable for a digital logic circuit. The integration of the CMOS and the SiGe HBT meets a requirement of a digital-analog hybrid circuit design. Therefore, compared with the III-V materials, the SiGe BiCMOS has advantages such as low costs and high integration.

With gradual popularization of 5G communication, the SiGe BiCMOS plays an increasingly important role in application of fields such as optoelectronic high-speed transmission, microwave high frequency, radar, images, and sensing. The SiGe HBT can be used to manufacture different radio frequency circuits such as an optoelectronic transimpedance amplifier, a driver, a microwave low noise amplifier, a frequency mixer, and a power amplifier, and used for clock data recovery (clock data recovery, CDR).

How to use a simple process to implement a SiGe HBT device with a higher frequency response has become a continuous goal of SiGe process engineers.

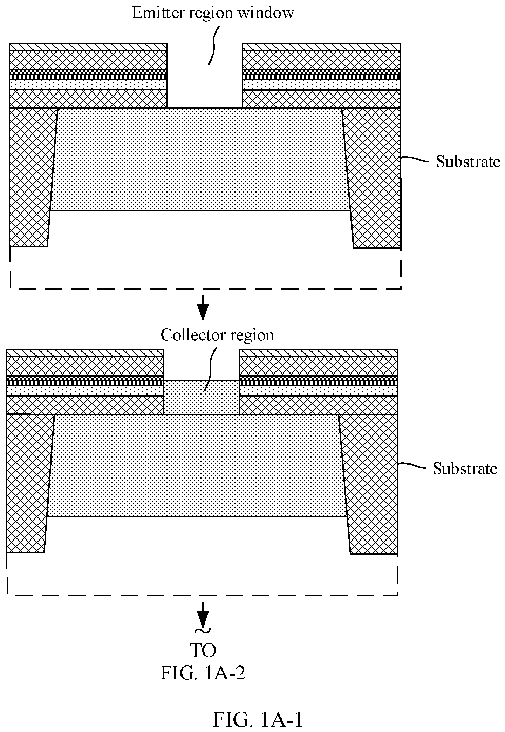

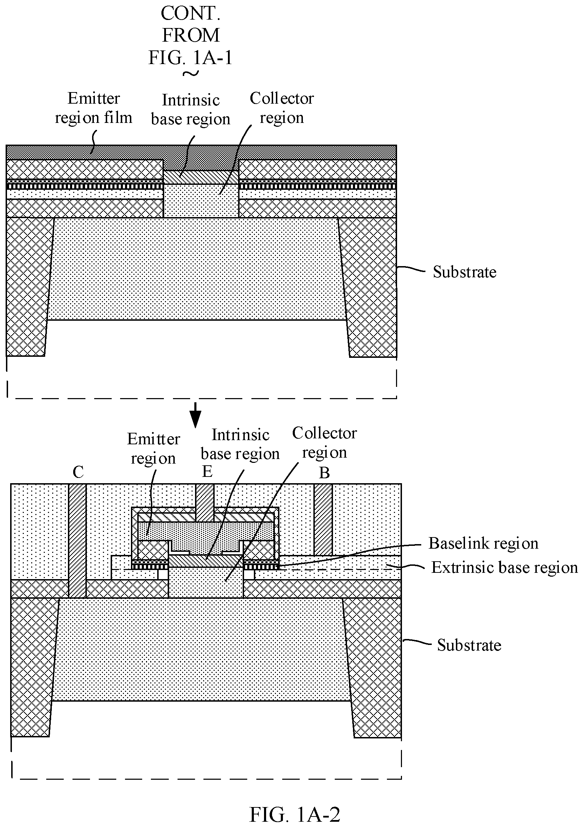

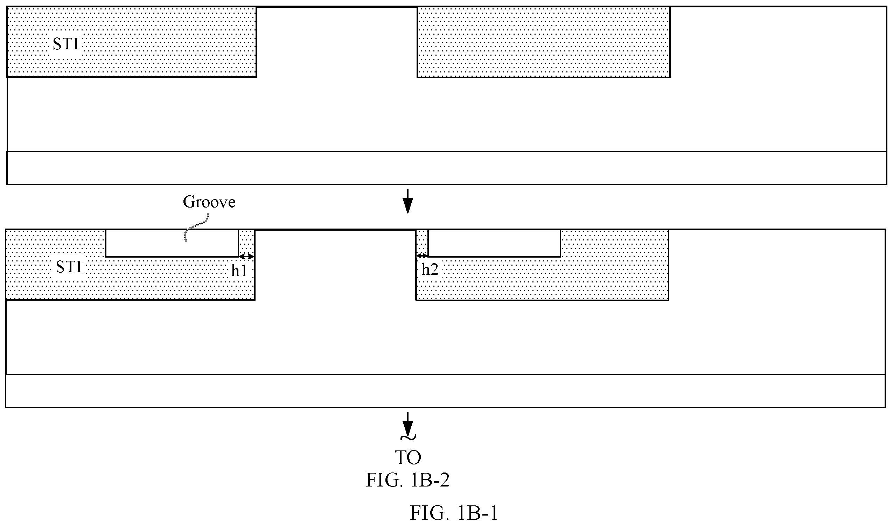

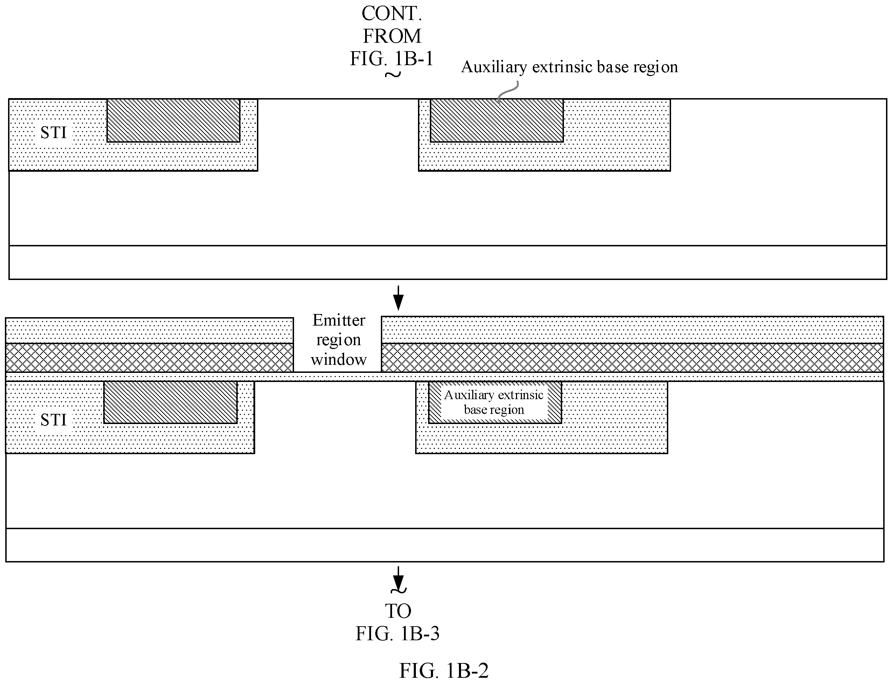

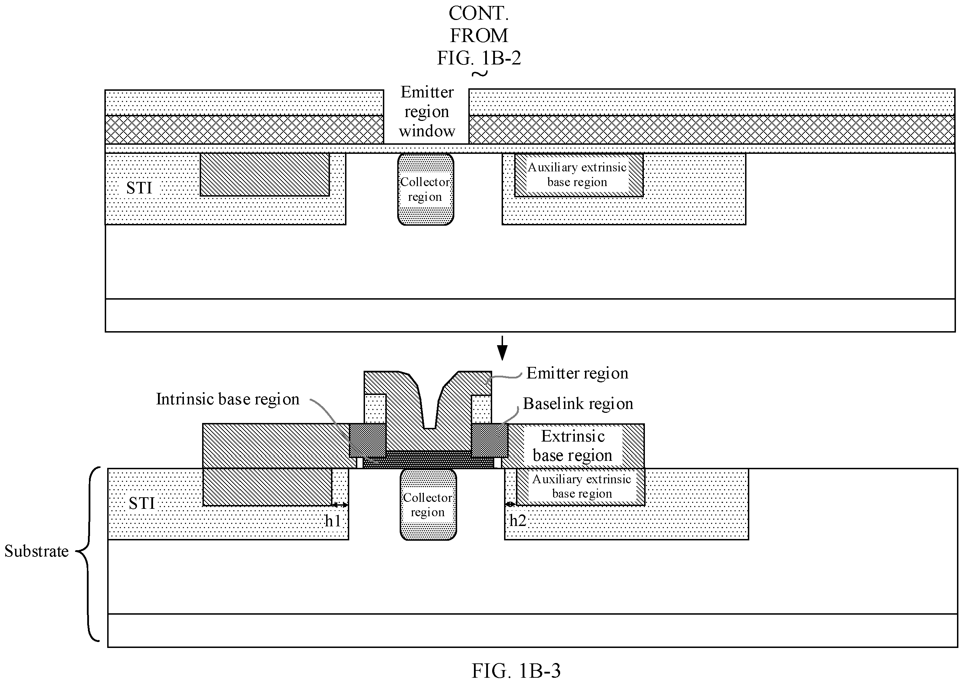

In some embodiments, as shown in FIG. 1A-1 and FIG. 1A-2, a preparation method for a semiconductor structure is provided. An emitter region window is first defined; a selective epitaxy growth (selective epitaxy growth, SEG) process is used on a substrate 10, to form a collector region in the emitter region window; the selective epitaxy growth process is used on the collector region, to form an intrinsic base region and an emitter region film in the emitter region window; and then structures such as the emitter region and an extrinsic base region are prepared subsequently. As shown in FIG. 1A-1 and FIG. 1A-2, in the semiconductor structure obtained through preparation by using the preparation method, the collector region, the intrinsic base region, and the emitter region are all disposed above the substrate.

The semiconductor structure is obtained through preparation by using the foregoing method. The semiconductor structure obtained through preparation by using a full self-alignment process in which the collector region, the intrinsic base region, and the emitter region grow in the same emitter region window has an advantage of a self-aligned structure. However, the selective epitaxy growth process is further used in the collector region, increasing preparation costs. Moreover, in the process of forming the collector region through epitaxy growth, height control of the collector region determines relative positions of the intrinsic base region and the extrinsic base region. As shown in FIG. 1A-1 and FIG. 1A-2, the intrinsic base region is in contact with the extrinsic base region through a baselink region. If a height of the collector region is not appropriate, the intrinsic base region disposed on the collector region and the baselink region have little or no contact, affecting connection resistance between the intrinsic base region and the extrinsic base region. In other words, the height of the collector region determines relative positions of the intrinsic base region and the baselink region, and directly affects the connection resistance between the intrinsic base region and the extrinsic base region, affecting device performance. Therefore, in a process of preparing the semiconductor structure, a high requirement is imposed on process precision. If the process precision does not meet the requirement, performance of the prepared semiconductor structure is greatly affected.

In view of this, as shown in FIG. 1B-1, FIG. 1B-2, and FIG. 1B-3, an embodiment of this application further provides a preparation method for a semiconductor structure. A shallow trench isolation (shallow trench isolation, STI) region is first formed; a groove is formed in the STI region under a to-be-formed extrinsic base region by using photoetching and etching processes; an auxiliary extrinsic base region is formed in the groove; an emitter region window is formed; a collector region buried in the substrate is formed by using the emitter region window as a self-aligned structure and by using a doping process; and then an intrinsic base region, a baselink region, the extrinsic base region, and an emitter region are formed on the substrate. As shown in FIG. 1B-1, FIG. 1B-2, and FIG. 1B-3, in the semiconductor structure obtained through preparation by using the preparation method, both the intrinsic base region and the extrinsic base region are disposed on a surface of the substrate, the collector region is disposed inside the substrate, and there is no raised epitaxial collector region on the surface of the substrate.

Therefore, the intrinsic base region and the extrinsic base region are directly formed on the surface of the known substrate, and whether the intrinsic base region is in contact with the extrinsic base region is directly controlled by preparation processes of the intrinsic base region and the extrinsic base region. In comparison with the intrinsic base region disposed on the epitaxial collector region that is disposed on the surface of the substrate, the intrinsic base region is directly disposed on the surface of the substrate. In this case, contact between the intrinsic base region and the extrinsic base region is not affected due to a parameter like thickness of the raised collector region. This can improve a contact yield between the intrinsic base region and the extrinsic base region, and further improve a yield of the semiconductor structure. In addition, because impact of the thickness of the collector region on effect of the contact between the intrinsic base region and the extrinsic base region does not need to be considered, a requirement for process precision during manufacture of the collector region may be reduced, and a process difficulty is reduced. In addition, the collector region is obtained through doping, and an epitaxy growth process (for preparing the collector region) is not needed, to save processing costs.

However, when grooves are formed in STI regions by using the photoetching and etching processes, thickness of remaining STI regions that are located in the grooves and that are away from an edge of the substrate is inconsistent due to an alignment deviation. In other words, sizes of h1 and h2 in FIG. 1B-1, FIG. 1B-2, and FIG. 1B-3 are inconsistent. Division is performed along a central line of the collector region, and consequently, a distance between the collector region and a left auxiliary extrinsic base region is not equal to a distance between the collector region and a right auxiliary extrinsic base region. Consequently, parasitic collector-base junction capacitance on both sides of the central line is asymmetric, a radio frequency current cannot be evenly distributed on both sides, effective collector-base junction capacitance of the device is affected, and a maximum oscillation frequency of the device is further affected.

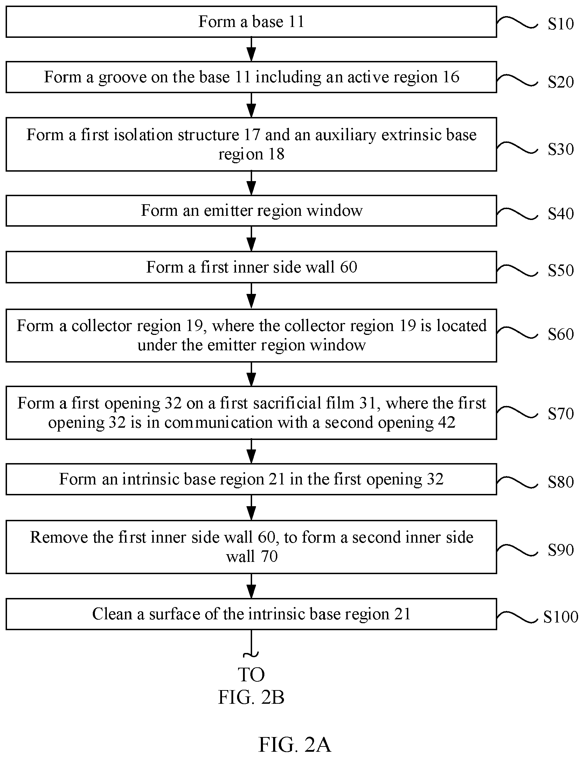

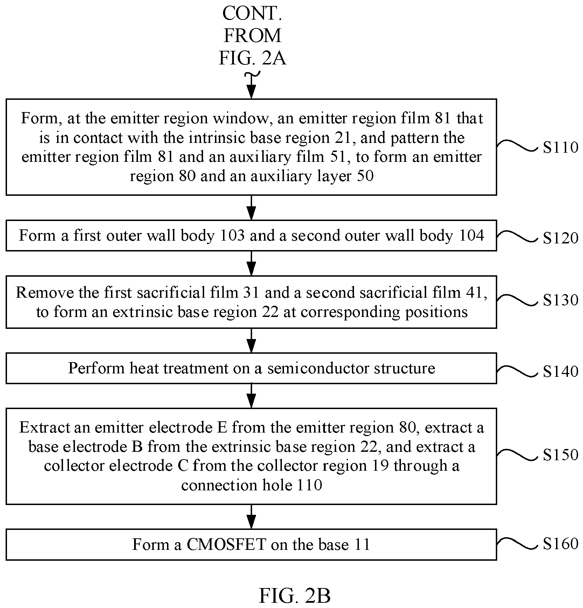

In view of this, an embodiment of this application further provides a preparation method for a semiconductor structure. As shown in FIG. 2A and FIG. 2B, the method includes the following steps.

S10: Form a base 11, as shown in FIG. 3A-1, FIG. 3A-2, FIG. 3A-3, and FIG. 3A-4.

In some embodiments, as shown in FIG. 3A-1, FIG. 3A-2, FIG. 3A-3, and FIG. 3A-4, a method for forming the base 11 includes the following steps.

S11: Form an epitaxial layer on a silicon substrate 12, and perform ion implantation on the epitaxial layer, to form a buried collector region 13 and a sinker (sinker) region 14.

The sinker region 14 is located outside a to-be-formed first isolation structure, and the buried collector region 13 is located under the sinker region 14 and is connected to the sinker region 14.

The buried collector region 13 may be implanted before the epitaxial layer is formed, and then diffused to the epitaxial layer at a high temperature. Alternatively, the buried collector region may be obtained by performing ion implantation after the epitaxial layer is formed. The foregoing order of forming the buried collector region 13 is merely an example. This is not limited.

Certainly, before the buried collector region 13 and the sinker region 14 are formed, a screen oxide (screen oxide) layer may be formed. In this way, the screen oxide layer can protect lattices of the silicon substrate 12 and the epitaxial layer from being damaged. After the buried collector region 13 and the sinker region 14 are formed, the screen oxide layer may be removed, and then subsequent steps are performed.

Alternatively, no epitaxial layer may be formed on the silicon substrate 12. In this case, the buried collector region 13 and the sinker region 14 are located in the silicon substrate 12. An embodiment of this application is described by using an example in which the epitaxial layer is formed on the silicon substrate 12.

S12: Form a silicon dioxide (SiO2) film and a silicon nitride (Si3N4) film at the epitaxial layer.

For example, the SiO2 film and the Si3N4 film cover the epitaxial layer.

S13: Form, from a surface of the Si3N4 film, a third isolation trench extending into the epitaxial layer.

For example, the third isolation trench is formed through photoetching and dry etching. It is clear that another process may alternatively be used.

The third isolation trench is located on a side that is of the sinker region 14 and that is away from a to-be-formed collector region. The third isolation trench may pass through the buried collector region 13, or may not pass through the buried collector region 13 based on a requirement. A shape of the third isolation trench may be a rectangle shown in FIG. 3A-1, FIG. 3A-2, FIG. 3A-3, and FIG. 3A-4, an inverted trapezoid, or another shape. This is not limited in embodiments of this application.

S14: Oxidize and repair an inner surface of the third isolation trench, to form a silicon dioxide interface.

The silicon dioxide interface covers a bottom of the third isolation trench and the inner surface of the trench wall.

S15: Fill the third isolation trench with a dielectric material, to form a filling layer.

The dielectric material is, for example, SiO2 or another field-effect oxide. The dielectric material may cover the Si3N4 film, or may not cover the Si3N4 film, but the third isolation trench needs to be fully filled with the dielectric material. FIG. 3A-1, FIG. 3A-2, FIG. 3A-3, and FIG. 3A-4 are shown by using an example in which the dielectric material covers the Si3N4 film.

S16: Process the filling layer, to form a third isolation structure 15.

For example, the filling layer may be ground through a chemical mechanical polishing (chemical mechanical polishing, CMP) process, to stay at a Si3N4 film layer.

S17: Remove a remaining Si3N4 film.

For example, the Si3N4 film may be removed through wet etching.

S18: Remove a remaining SiO2 film, to form the base 11.

In this way, a region filled with the dielectric material at the epitaxial layer is the third isolation structure 15. When the base 11 does not include another structure, a remaining region other than the buried collector region 13, the sinker region 14, and the third isolation structure 15 is the active region 16 of the base 11.

The third isolation structure 15 may be a shallow trench isolation structure (for example, the buried collector region 13 is not passed through). In this case, a material of the third isolation structure 15 may be, for example, SiO2. The third isolation structure 15 may alternatively be a deep trench isolation structure (for example, the buried collector region 13 is passed through). In this case, a material of the third isolation structure 15 may be, for example, SiO2+polycrystalline silicon. It is clear that if the third isolation structure 15 does not need to be formed, the third isolation structure 15 may not be formed on the base 11. The third isolation structure is properly set as required.

In view of this, as shown in FIG. 3A-1, FIG. 3A-2, FIG. 3A-3, and FIG. 3A-4, the base 11 includes the silicon substrate 12 and the epitaxial layer disposed on the silicon substrate 12. The epitaxial layer is divided into the third isolation structure 15, the active region 16, the buried collector region 13, and the sinker region 14. The sinker region 14 is located on the buried collector region 13, and the sinker region 14 is in contact with the buried collector region 13.

It is clear that the preparation process of the base 11 is not limited to the foregoing steps, and may further include another step, or some of the foregoing steps are removed. The process of preparing the base 11 shown in FIG. 3A-1, FIG. 3A-2, FIG. 3A-3, and FIG. 3A-4 is merely an example, and does not constitute any limitation.

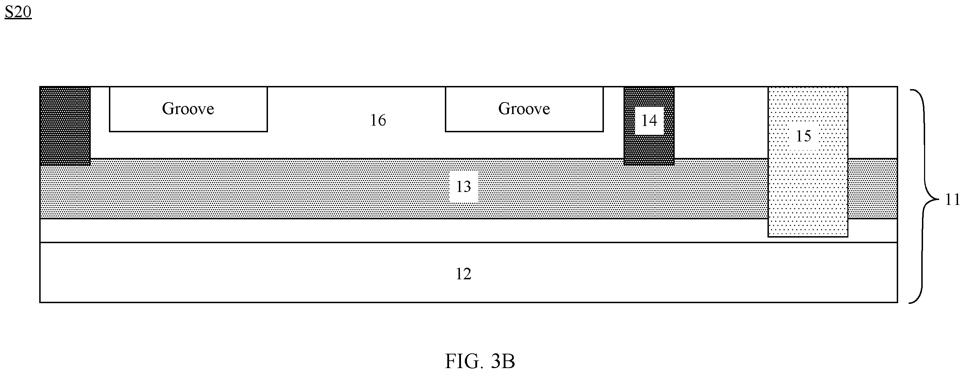

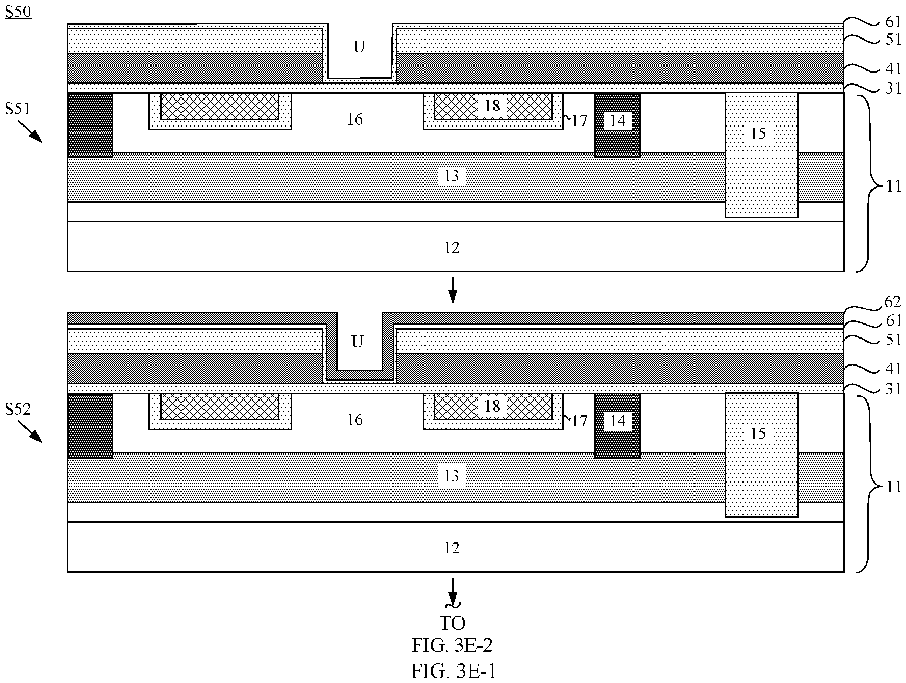

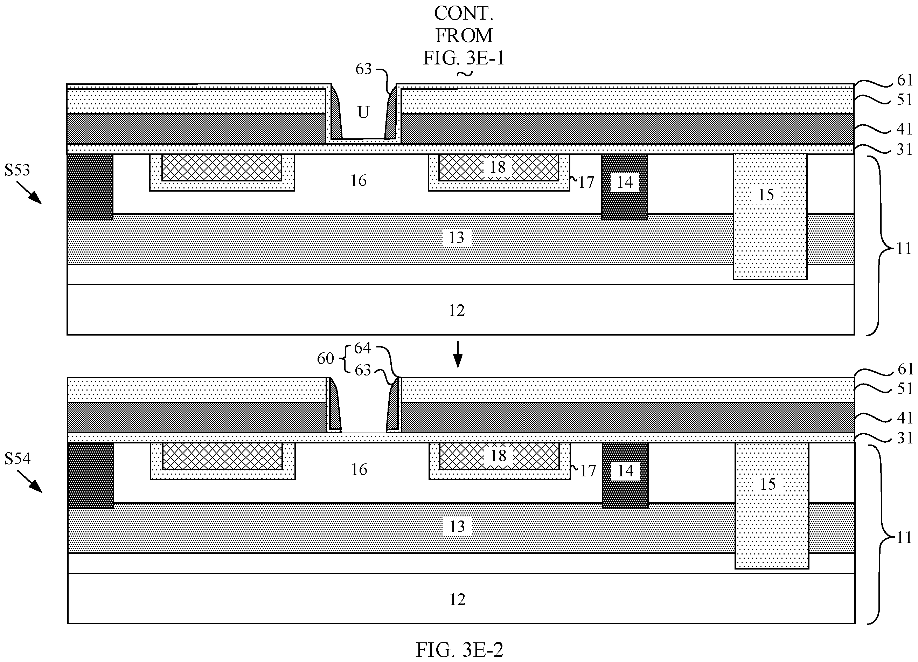

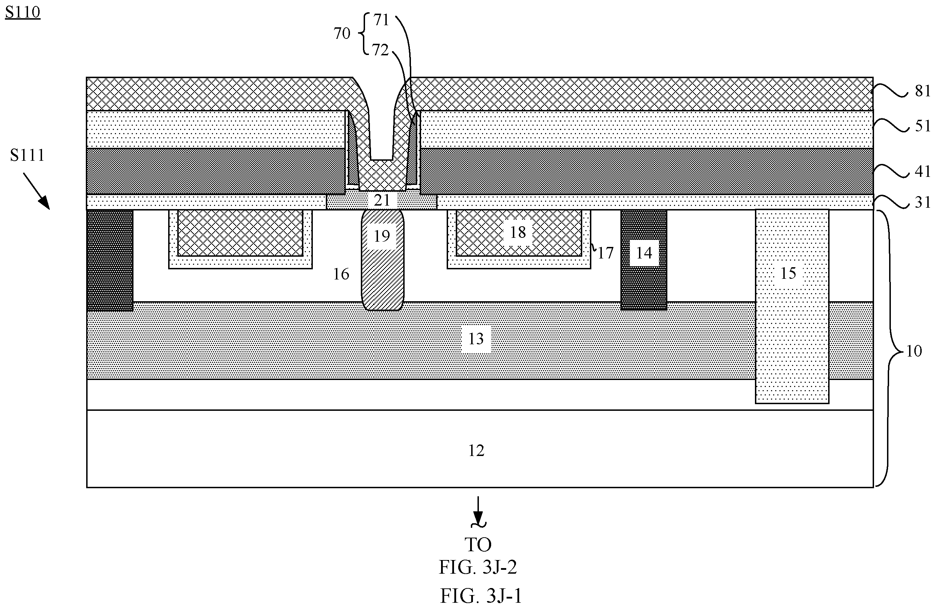

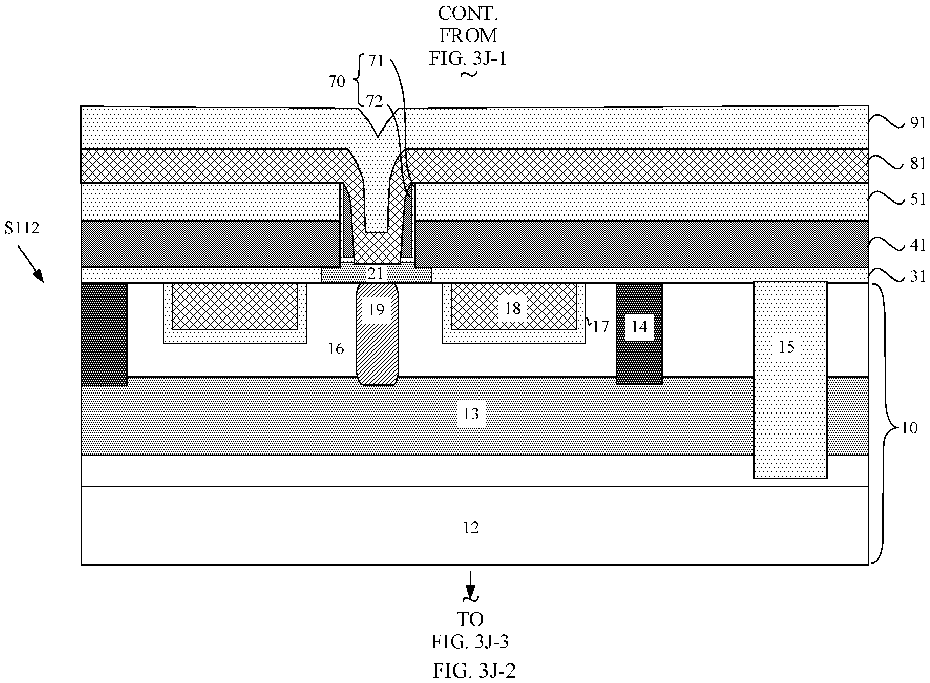

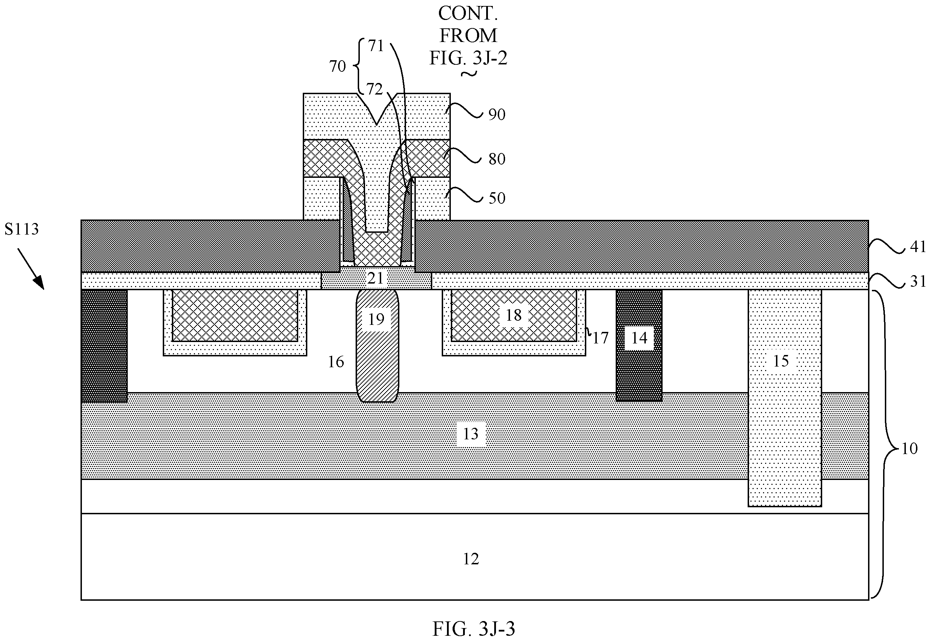

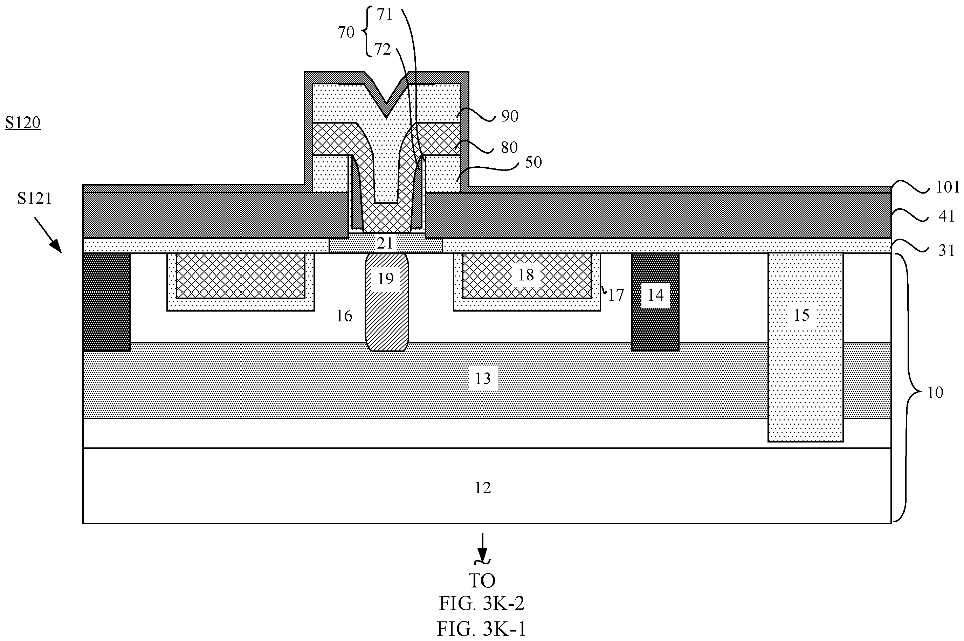

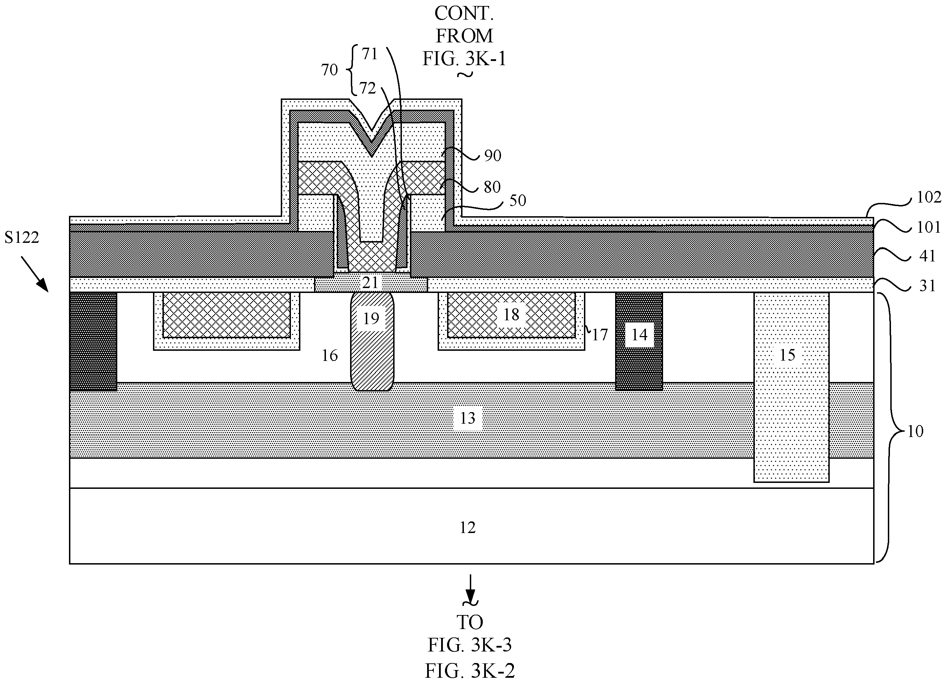

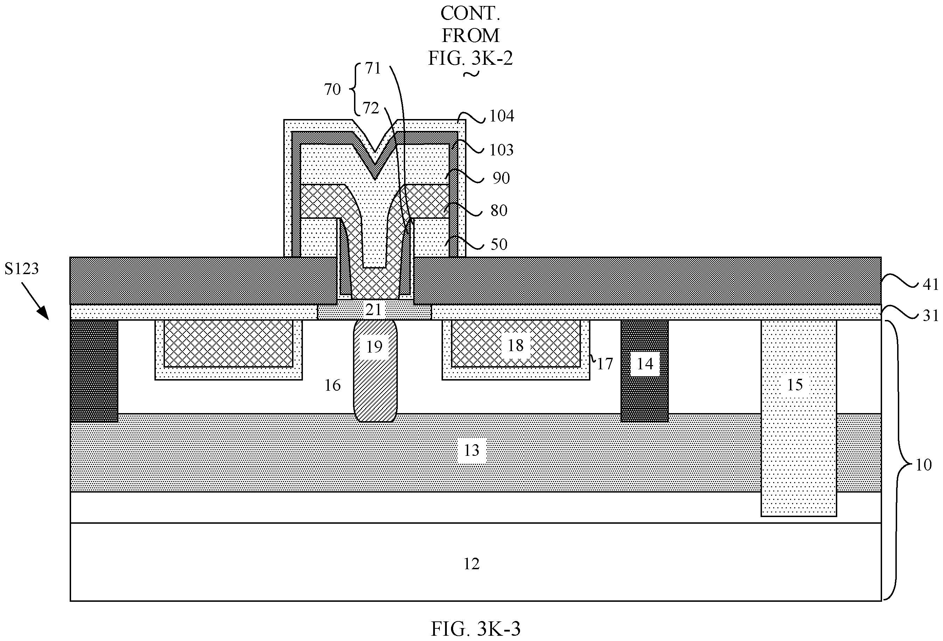

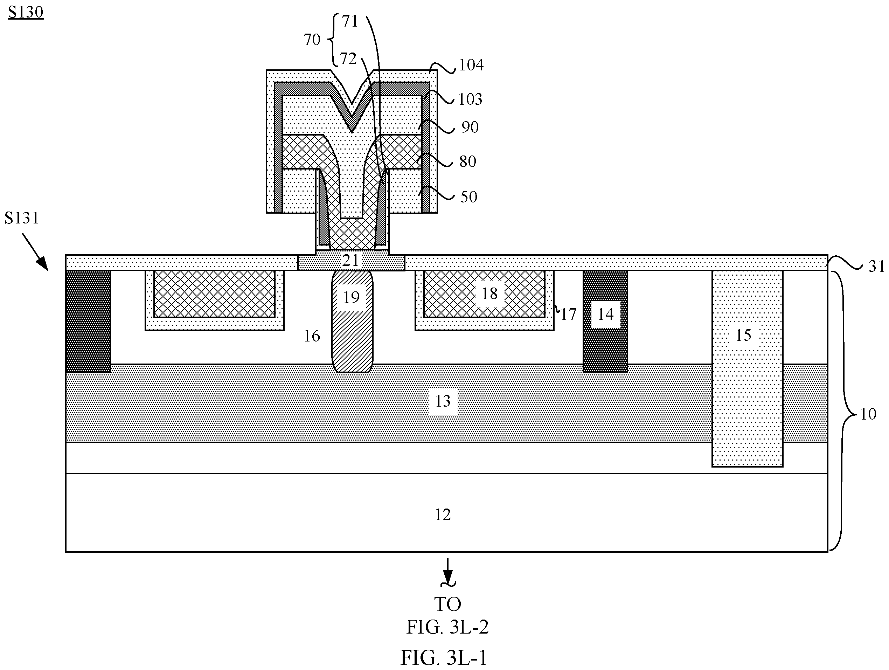

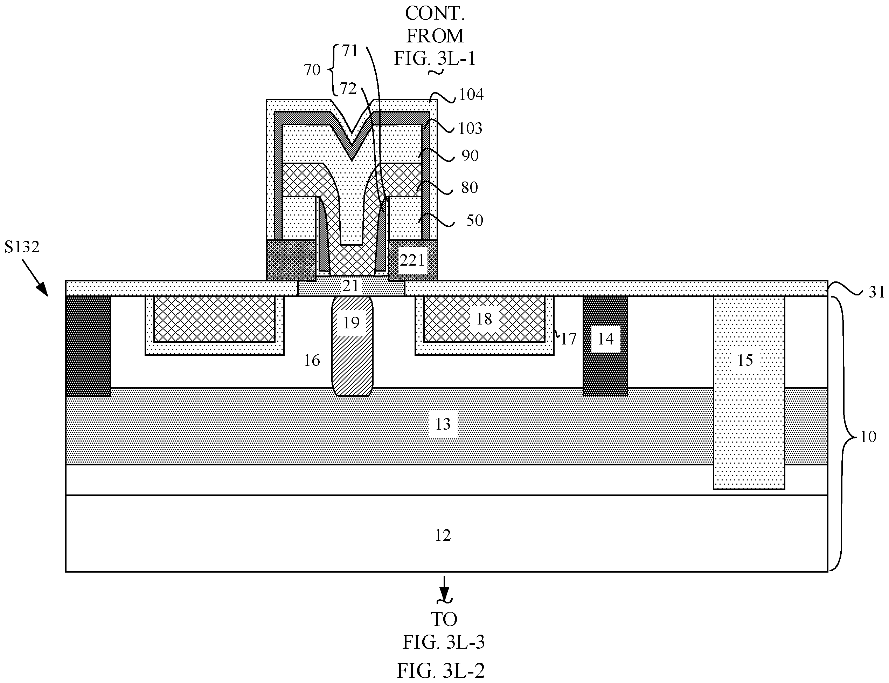

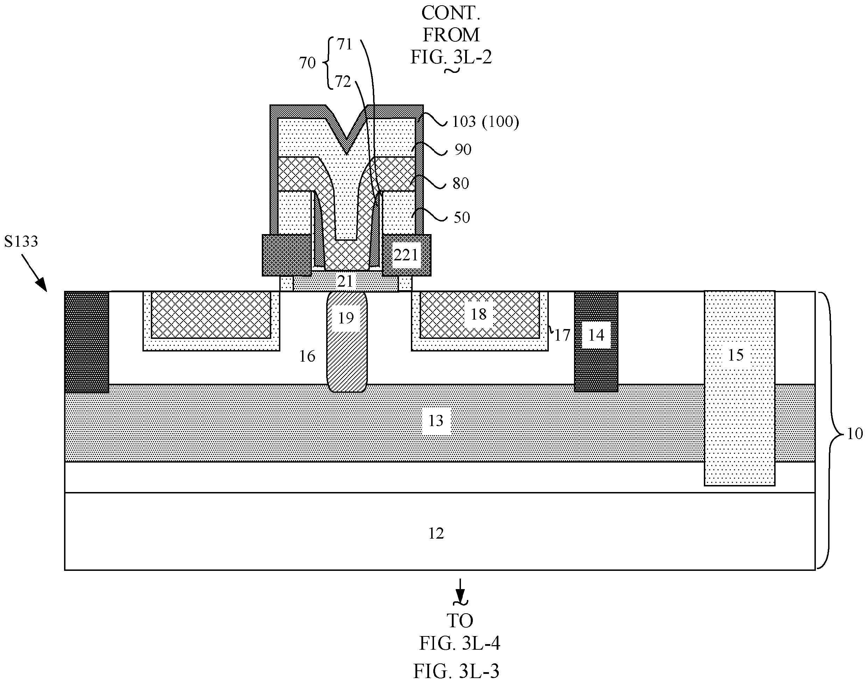

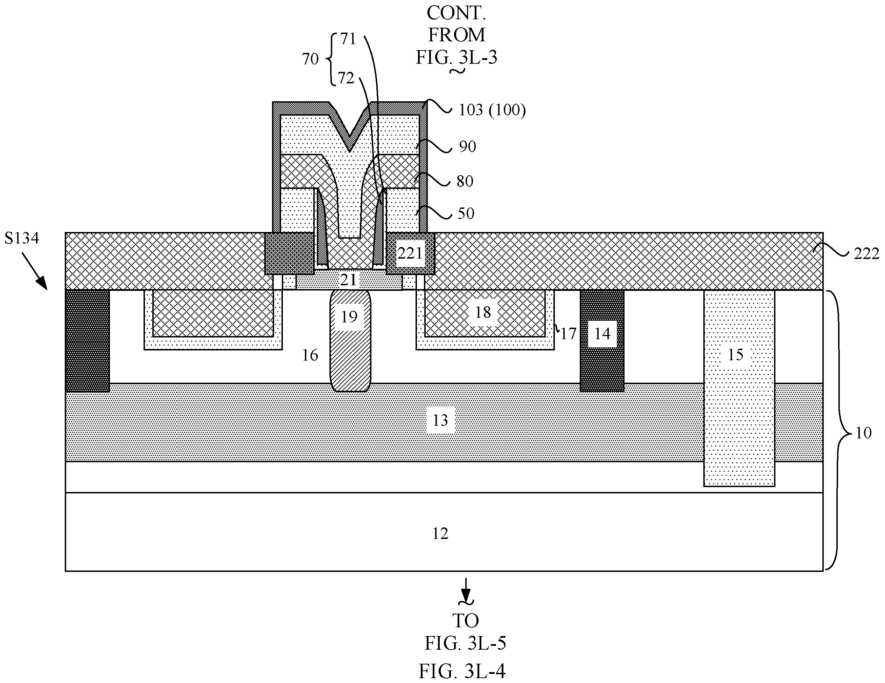

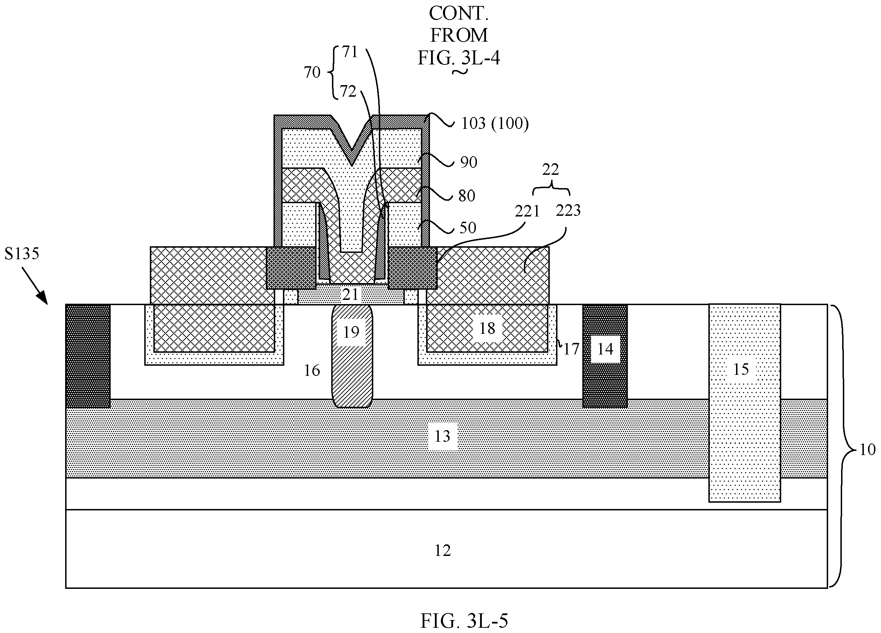

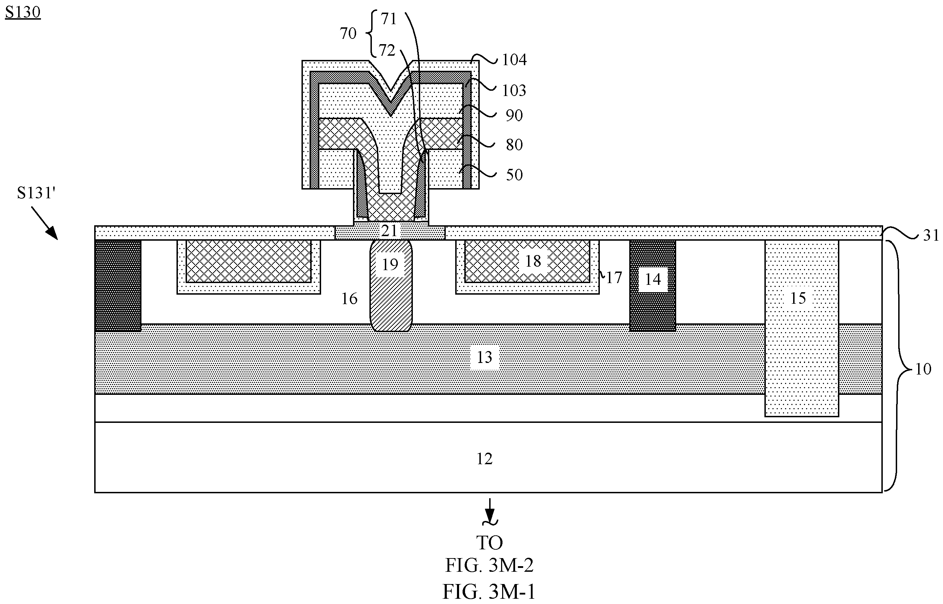

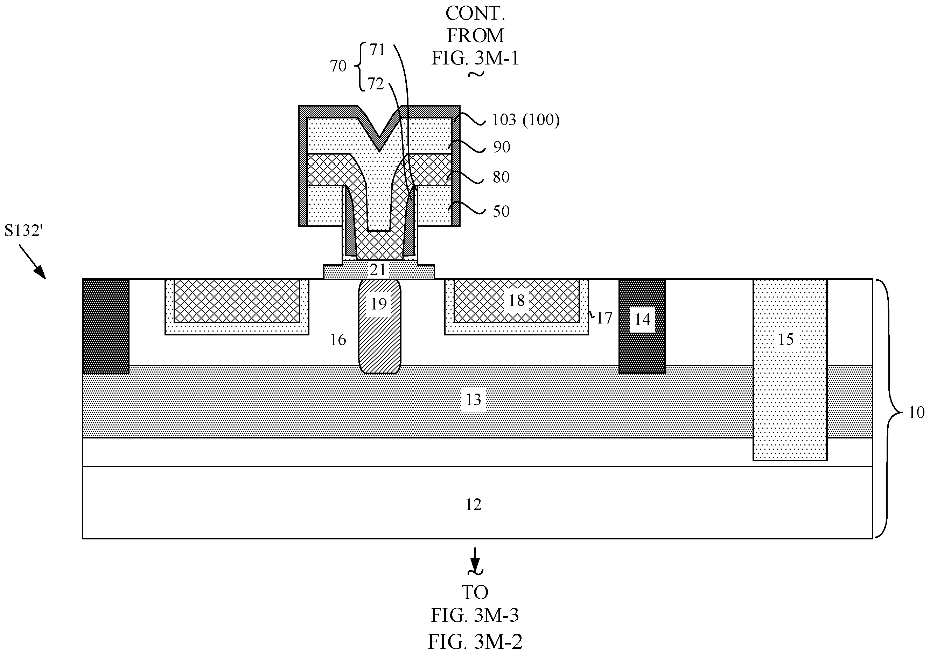

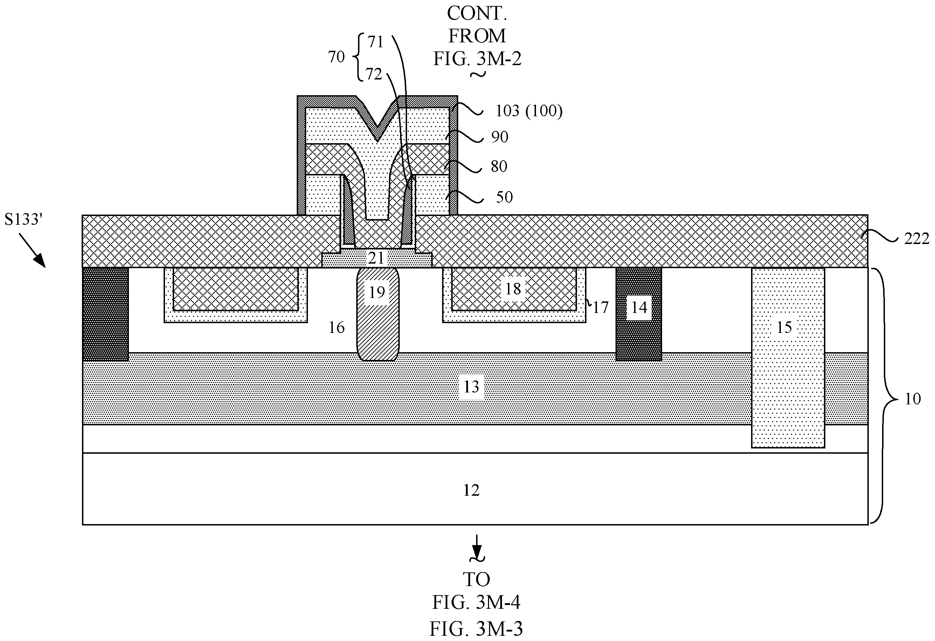

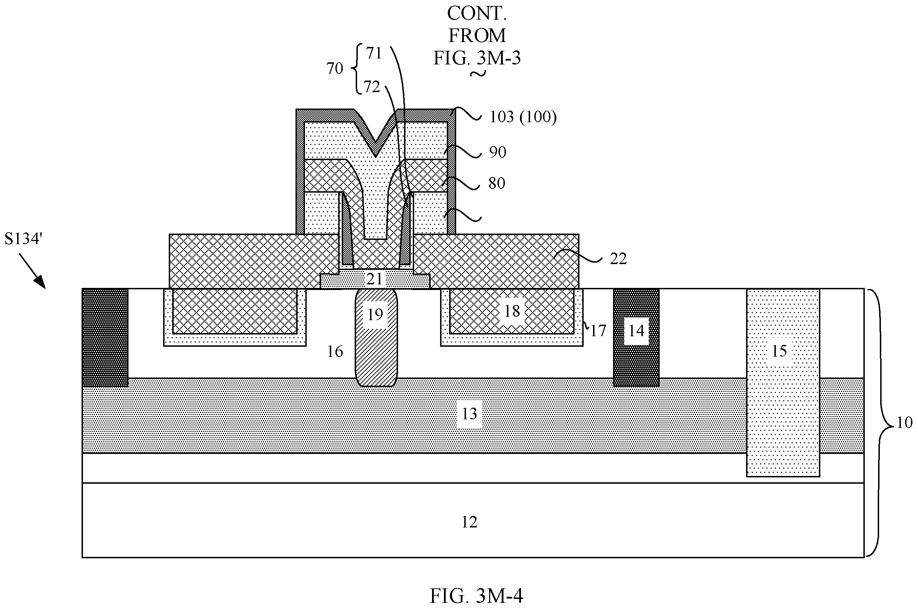

S20: Form a groove on the base 11 including the active region 16, as shown in FIG. 3B.

In some embodiments, as shown in FIG. 3B, the groove is formed in the active region 16 of the base 11. The groove is located under a to-be-formed extrinsic base region.

For example, the groove is formed in the active region 16 through photolithography and dry etching.

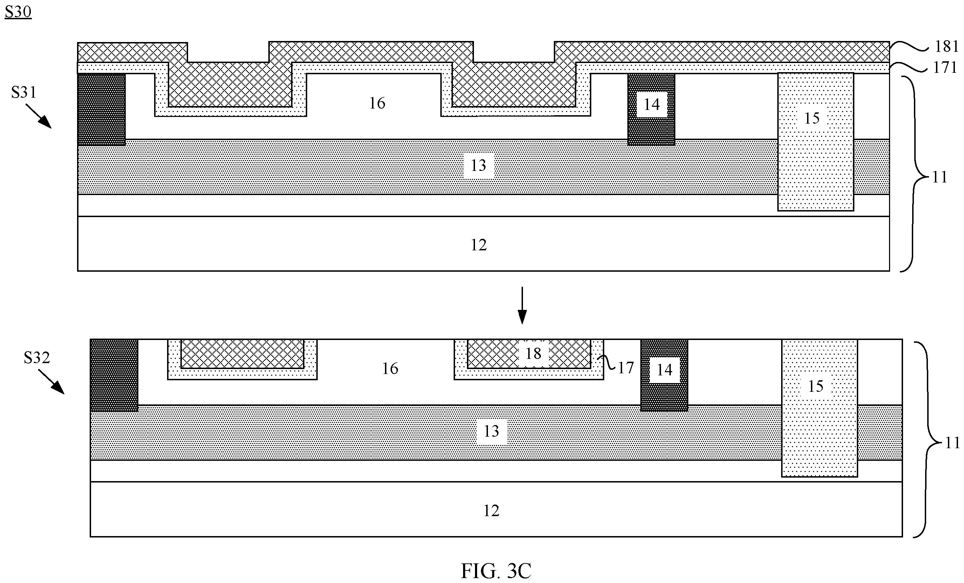

S30: Form a first isolation structure 17 and an auxiliary extrinsic base region 18, as shown in FIG. 3C.

In some embodiments, as shown in FIG. 3C, step S30 further includes:

S31: Sequentially form an isolation film 171 and an auxiliary extrinsic base region film 181 on the base 11 on which the groove is formed, as shown in FIG. 3C.

For example, a chemical vapor deposition (chemical vapor deposition, CVD) process may be used to form the isolation film 171. The isolation film 171 may be understood as a dielectric layer, and a material of the isolation film 171 may be silicon-containing oxide. For example, the material of the isolation film 171 is SiO2, silicon oxynitride, or oxygen-rich silicon dioxide.

For example, an epitaxy growth process or the chemical vapor deposition (chemical vapor deposition, CVD) process may be used to form the auxiliary extrinsic base region film 181. A material of the auxiliary extrinsic base region film 181 may be polycrystalline silicon, polycrystalline silicon silicide, or the like.

In some embodiments, after the auxiliary extrinsic base region film 181 is formed, doping may further be performed on the auxiliary extrinsic base region film 181. In-situ doping may be performed on the auxiliary extrinsic base region film 181, or the auxiliary extrinsic base region film 181 may be formed first and then ion implantation is performed to implement doping.

S32: Pattern the isolation film 171 and the auxiliary extrinsic base region film 181, to form the first isolation structure 17 and the auxiliary extrinsic base region 18, as shown in FIG. 3C.

In some embodiments, a surface of the auxiliary extrinsic base region 18 is higher than a surface of the base 11.

For example, the auxiliary extrinsic base region film 181 may be ground by using the CMP process, to remove the auxiliary extrinsic base region film 181 located outside the groove. Then, wet etching may be performed, or dry etching may be performed, to remove a redundant isolation film 171 on the surface of the base 11.

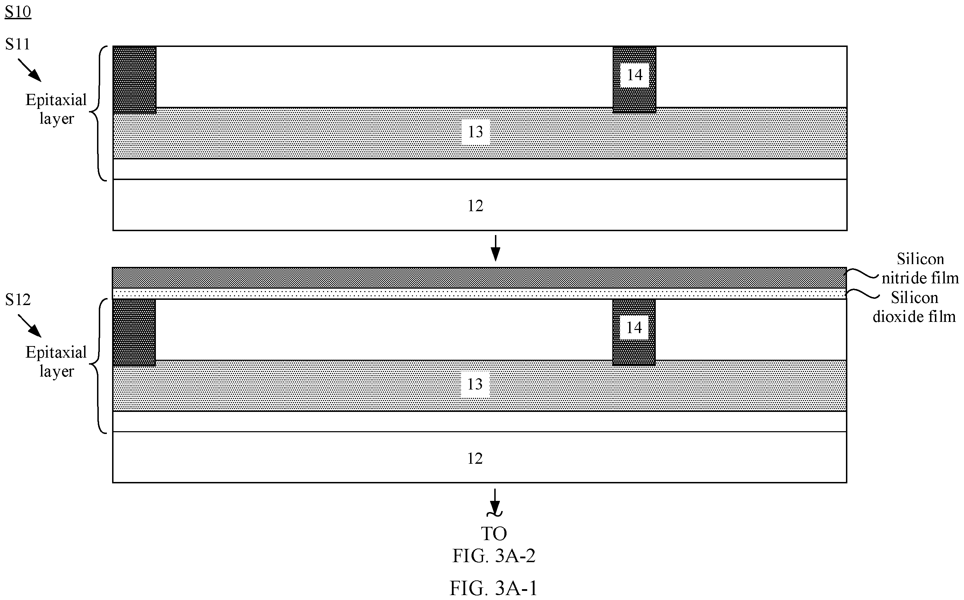

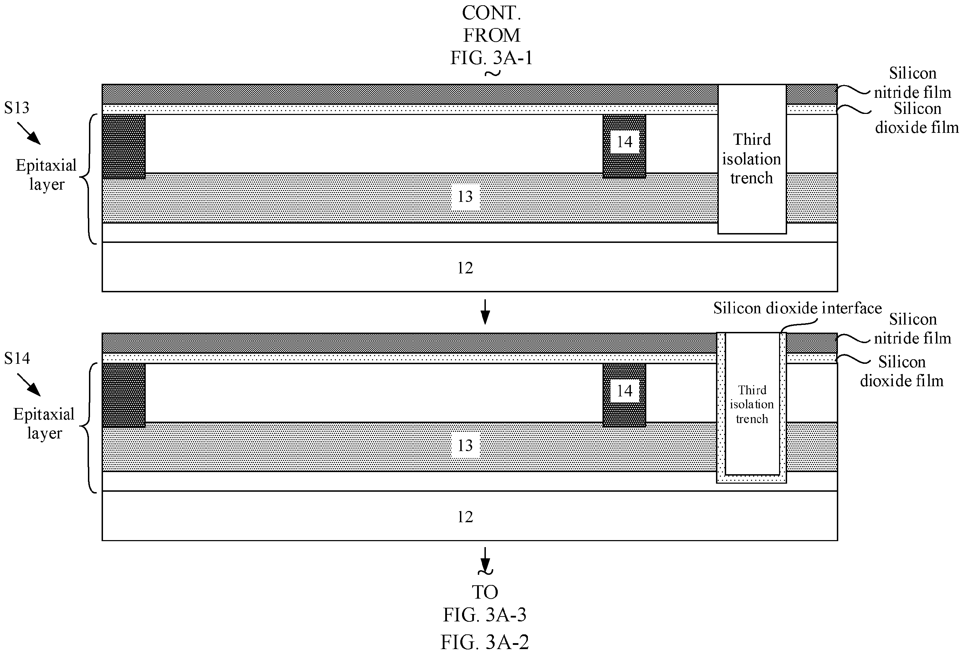

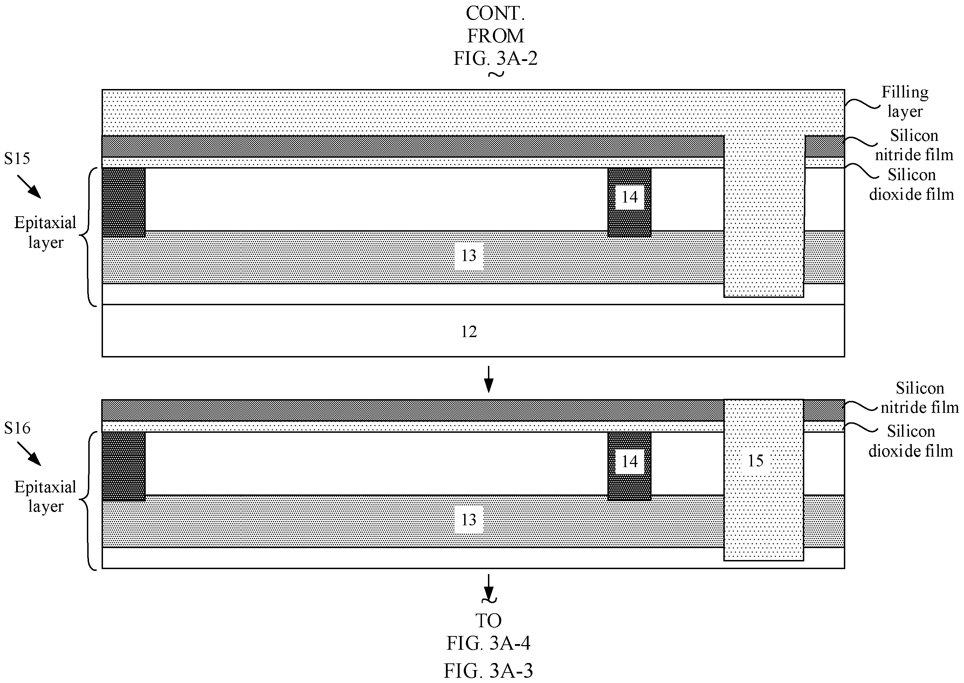

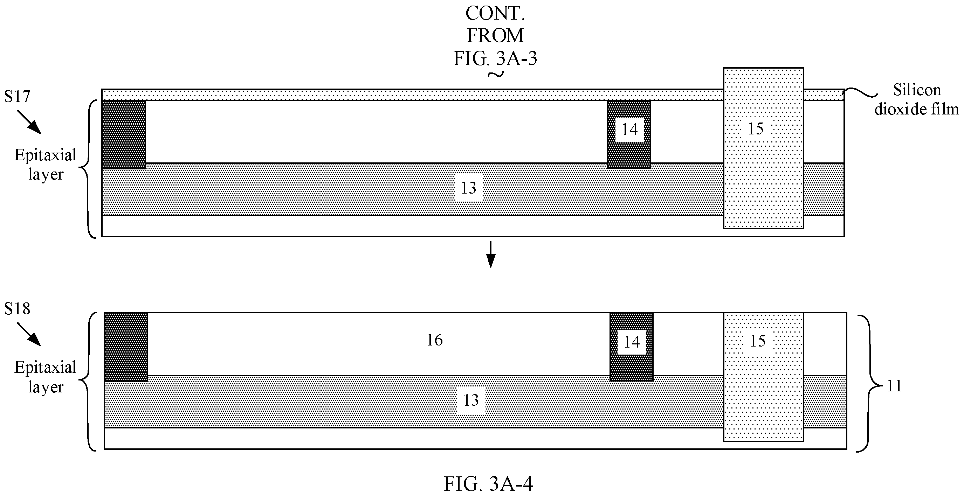

In some other embodiments, as shown in FIG. 3C, a surface of the auxiliary extrinsic base region 18 is flush with the surface of the base 11.

For example, the base 11 may be ground by using the CMP process, so that surfaces of the first isolation structure 17 and the auxiliary extrinsic base region 18 are flush with the surface of the base 11. In visual effect, this is equivalent to burying the first isolation structure 17 in the base 11, and burying the auxiliary extrinsic base region 18 in the first isolation structure 17.

It is clear that the surfaces of the first isolation structure 17 and the auxiliary extrinsic base region 18 being flush with the surface of the base 11 may include absolute flushing and approximately flushing.

In view of this, as shown in FIG. 3C, the formed first isolation structure 17 and the auxiliary extrinsic base region 18 are located in the groove, the auxiliary extrinsic base region 18 is disposed under the to-be-formed extrinsic base region 22, and the first isolation structure 17 wraps a side surface and a bottom surface of the auxiliary extrinsic base region 18. For example, the first isolation structure 17 is in contact with the side surface and the bottom surface of the auxiliary extrinsic base region 18. It is clear that another structure may also be disposed between the first isolation structure 17 and the side surface and/or the bottom surface of the auxiliary extrinsic base region 18 based on a requirement.

It should be emphasized that, it can be learned from the foregoing descriptions that the first isolation structure 17 is obtained by preparing the isolation film 171. When the isolation film 171 is formed, thickness of the isolation film 171 is the same or approximately the same at all positions. It is clear that a height difference (for example, thickness of the isolation film 171 ± 10%) within a process error range falls within the protection scope of embodiments of this application. Therefore, thickness of the finally formed first isolation structure 17 is the same or approximately the same at all positions. The thickness of the isolation film 171 may be, for example, 1 nm to 100 nm. For example, the thickness of the isolation film 171 is 10 nm, 20 nm, 30 nm, 40 nm, 50 nm, 60 nm, 70 nm, 80 nm, or 90 nm.

The thickness of the first isolation structure 17 may be understood as a size from a surface that is of the first isolation structure 17 and that is close to the auxiliary extrinsic base region 18 to a surface that is away from the auxiliary extrinsic base region 18, or understood as the thickness of the isolation film 171.

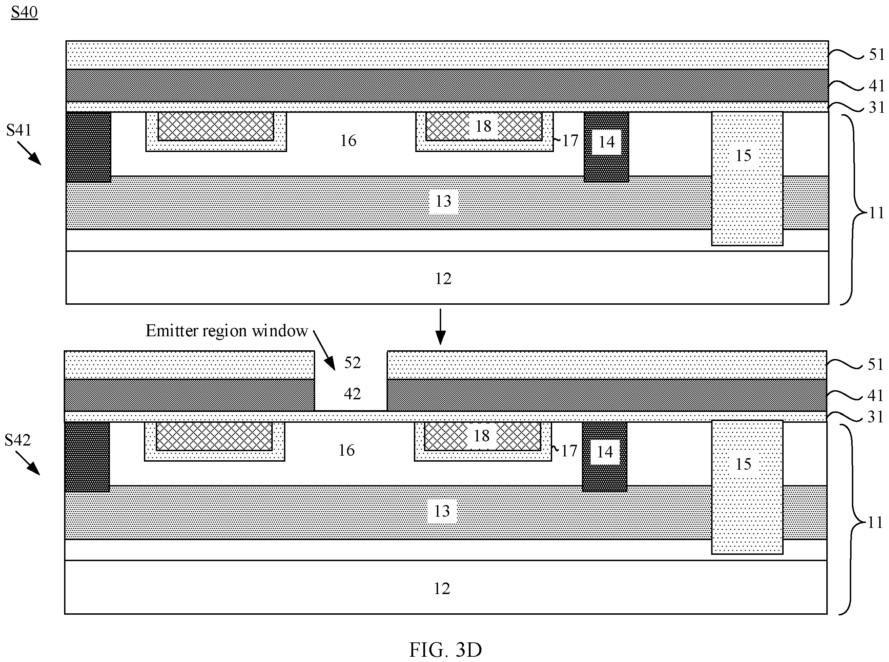

S40: Form an emitter region window, as shown in FIG. 3D.

In some embodiments, a manner of forming the emitter region window includes the following steps.

S41: Form a first sacrificial film 31, a second sacrificial film 41, and an auxiliary film 51 that are sequentially stacked on the surface of the base 11, as shown in FIG. 3D.

Materials of the first sacrificial film 31 and the auxiliary film 51 are the same, and materials of the first sacrificial film 31 and the second sacrificial film 41 are different.

For example, materials of the first sacrificial film 31, the second sacrificial film 41, and the auxiliary film 51 may all be, for example, silicide.

For example, materials of the first sacrificial film 31 and the auxiliary film 51 are silicon-containing oxide. For example, materials of the first sacrificial film 31 and the auxiliary film 51 are SiO2, silicon oxynitride, or oxygen-rich silicon dioxide.

For example, the material of the second sacrificial film 41 is silicon-containing nitride. For example, the material of the second sacrificial film 41 is Si3N4.

A manner of forming the first sacrificial film 31, the second sacrificial film 41, and the auxiliary film 51 may be, for example, using the chemical vapor deposition (chemical vapor deposition, CVD) process to form the first sacrificial film 31, the second sacrificial film 41, and the auxiliary film 51.

S42: Form a third opening 52 on the auxiliary film 51, and form a second opening 42 on the second sacrificial film 41, to form an emitter region window that passes through the auxiliary film 51 and the second sacrificial film 41, as shown in FIG. 3D.

For example, the third opening 52 may be formed on the auxiliary film 51 by using photoetching and etching processes. The second opening 42 may be formed on the second sacrificial film 41 by using the photoetching and etching processes.

The third opening 52 and the second opening 42 may be formed in two processes, or may be formed in a same process. This is not limited in embodiments of this application.

As shown in FIG. 3D, the formed second opening 42 is in communication with the third opening 52 to function as the emitter region window. The first sacrificial film 31 is still reserved at a bottom of the emitter region window, and is not directly connected to the base 11.

In some embodiments, as shown in FIG. 3D, the second opening 42 and the third opening 52 are directly opposite to each other and have a same size. Alternatively, it is understood as that an orthographic projection of the second opening 42 on the base 11 coincides with an orthographic projection of the third opening 52 on the base 11.

S50: Form a first inner side wall 60, as shown in FIG. 3E-1 and FIG. 3E-2.

The formed first inner side wall 60 is disposed around a surface that is of the second sacrificial film 41 and that faces the second opening 42 (or the emitter region window).

In some embodiments, as shown in FIG. 3E-1 and FIG. 3E-2, the formed first inner side wall 60 further extends to a surface that is of the auxiliary film 51 and that faces the third opening 52.

In some embodiments, as shown in FIG. 3E-1 and FIG. 3E-2, a manner of forming the first inner side wall 60 includes:

S51: Form a first dielectric film 61 on a surface of the auxiliary film 51, where the first dielectric film 61 forms a groove U at the emitter region window.

A material of the first dielectric film 61 may be a dielectric material, and the material of the first dielectric film 61 is, for example, silicone. For example, the material of the first dielectric film 61 is SiO2, Si3N4, silicon oxynitride, or oxygen-rich silicon dioxide.

In some embodiments, the material of the first dielectric film 61 is different from a material of the second sacrificial film 41. For example, the material of the first dielectric film 61 is SiO2, and the material of the second sacrificial film 41 is Si3N4.

A manner of forming the first dielectric film 61 may be, for example, forming the first dielectric film 61 by using the CVD process.

S52: Form a second dielectric film 62 on the first dielectric film 61.

A manner of forming the second dielectric film 62 may be, for example, forming the second dielectric film 62 by using the CVD process.

A material of the second dielectric film 62 may be a dielectric material, and the material of the second dielectric film 62 is, for example, silicone. For example, the material of the second dielectric film 62 is SiO2, Si3N4, silicon oxynitride, or oxygen-rich silicon dioxide.

In some embodiments, the material of the first dielectric film 61 is different from the material of the second dielectric film 62. For example, the material of the first dielectric film 61 is SiO2, and the material of the second dielectric film 62 is Si3N4.

In other words, in some embodiments, the material of the second sacrificial film 41 is Si3N4, the material of the first dielectric film 61 is SiO2, and the material of the second dielectric film 62 is Si3N4.

In this way, the first dielectric film 61 blocks a side surface of the second sacrificial film 41, to prevent damage to the second sacrificial film 41 when the second dielectric film 62 is patterned.

S53: Pattern the second dielectric film 62, to form a second inner wall body 63, where the second inner wall body 63 covers a side surface of the groove U.

For example, the second dielectric film 62 may be patterned by using the dry etching process, to form the second inner wall body 63.

S54: Remove a part that is of the first dielectric film 61 and that is not covered by the second inner wall body 63, to form a first inner wall body 64.

For example, the first dielectric film 61 may be patterned by using the dry etching process, to form the first inner wall body 64.

In view of this, as shown in FIG. 3E-1 and FIG. 3E-2, the first inner side wall 60 of the semiconductor structure includes the first inner wall body 64 and the second inner wall body 63. The first inner side wall 60 exposes the first sacrificial film 31.

It is clear that step S44 may not be performed, and when a collector region 18 is subsequently formed, the first dielectric film 61 and the first sacrificial film 31 jointly function as the screen oxide layer.

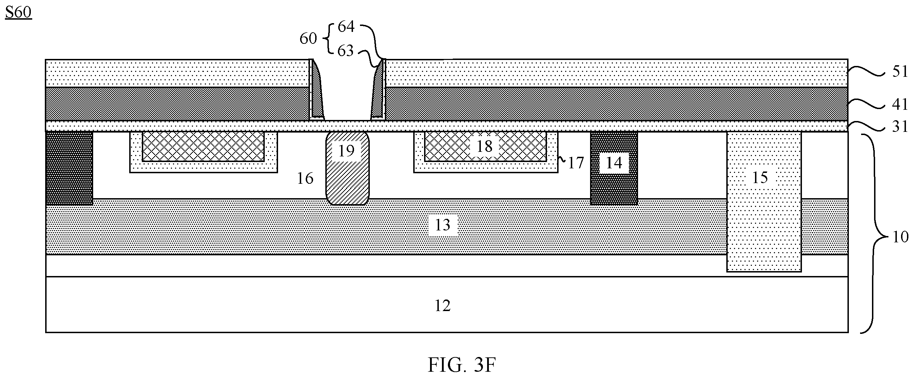

S60: Form the collector region 19, where the collector region 19 is located under the emitter region window, as shown in FIG. 3F.

As shown in FIG. 3F, after step S60 is performed, the collector region 19 is formed in the base 11, and a substrate 10 of the semiconductor structure is prepared. The prepared substrate 10 includes the first isolation structure 17, the auxiliary extrinsic base region 18, and the collector region 19 that are buried in the substrate 10.

The emitter region window functions as a self-aligned window, the first sacrificial film 31 functions as the screen oxide (screen oxide) layer, and an ion implantation process is used in selective implantation (selected implanted), to form the collector (collector) region 19. In this way, the screen oxide layer can protect a lattice of the base 11 from being damaged, and the prepared collector region 19 is well directly aligned with the emitter region window. After an emitter region is subsequently formed in the emitter region window, alignment effect between the emitter region and the collector region 19 is good.

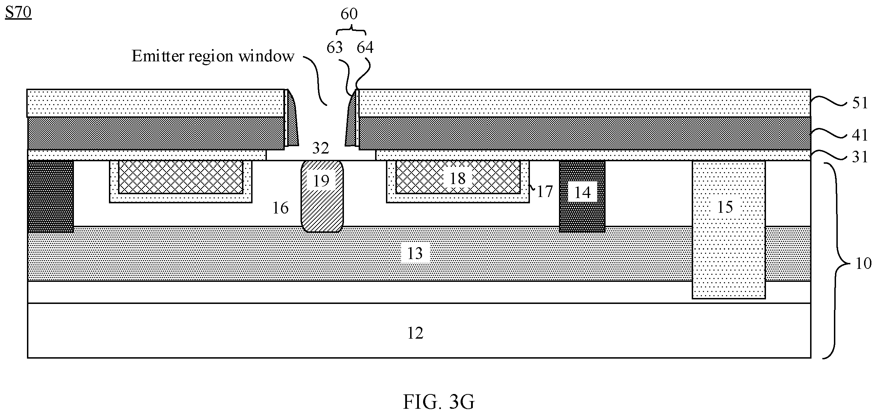

S70: Form a first opening 32 on the first sacrificial film 31, where the first opening 32 is in communication with the emitter region window, as shown in FIG. 3G.

For example, the first sacrificial film 31 located under the second opening 42 is removed through wet etching, to form the first opening 32. Because wet etching is isotropic, if materials of the first inner wall body 64 and the first sacrificial film 31 are the same (for example, the materials are SiO2), in a process of forming the first opening 32, the first inner wall body 64 located under the second inner wall body 63 is also removed.

It should be understood that an etching amount of the first sacrificial film 31 may be controlled by controlling etching time. In other words, a size of the first opening 32 may be controlled by controlling the etching time.

In some embodiments, to improve effect of contact between an extrinsic base region and an intrinsic base region that are subsequently prepared, as shown in FIG. 3G, a contour of an emitter region window falls within a contour of the first opening 32. Alternatively, it is understood as that an orthographic projection of the emitter region window on the substrate 10 falls within an orthographic projection of the first opening 32 on the substrate 10. In other words, the first opening 32 is larger than the emitter region window, and there is a hole under the second sacrificial film 41.

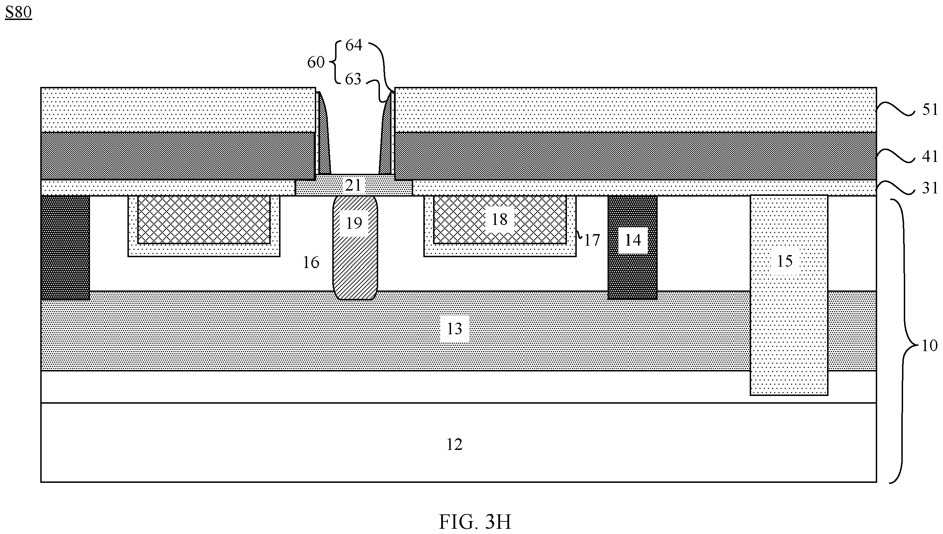

S80: Form an intrinsic base region 21 in the first opening 32, as shown in FIG. 3H.

For example, the intrinsic base region 21 may be selectively epitaxially grown on a surface of the substrate 10 by using a selective epitaxy growth process. A material of the intrinsic base region 21 may include, for example, SiGe (silicon germanium) and SiGe:C (silicon-germanium-carbon) alloy.

As shown in FIG. 3H, when there is the hole under the second sacrificial film 41, the hole is filled with the intrinsic base region 21.

The intrinsic base region 21 is in contact with the collector region 19 on the surface of the substrate 10.

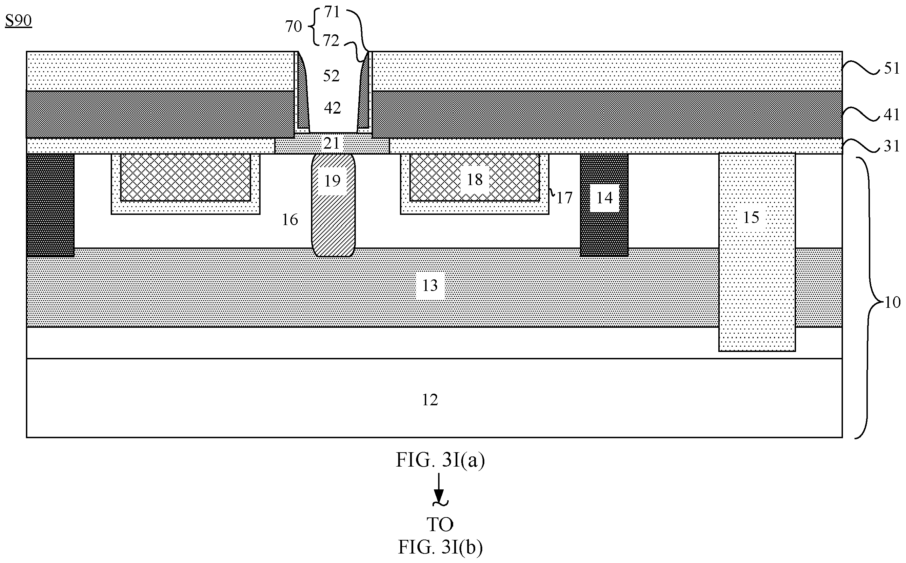

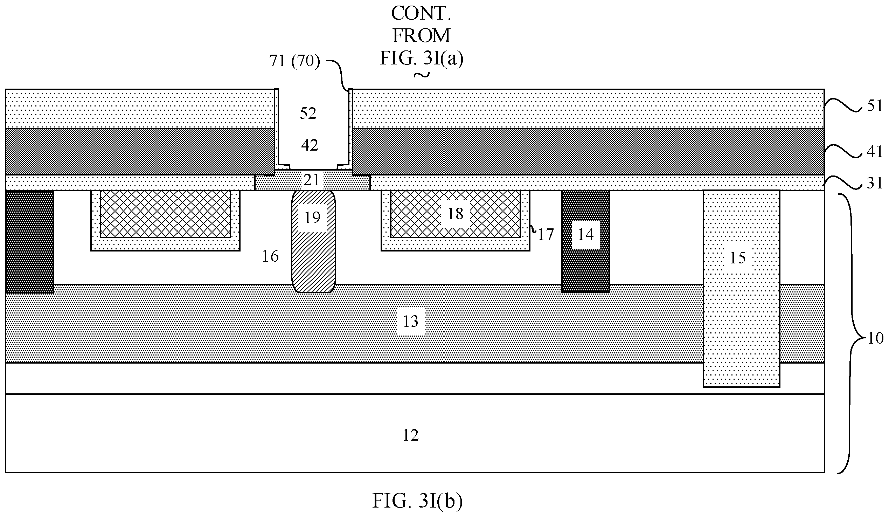

S90: Remove the first inner side wall 60, to form a second inner side wall 70, as shown in FIG. 3I(a) and FIG. 3I(b).

A method for forming the second inner side wall 70 may be the same as the foregoing method for forming the first inner side wall 60. For details, refer to the foregoing descriptions of step S50. Details are not described herein again.

In some embodiments, as shown in FIG. 3I(a), the formed second inner side wall 70 includes a third inner wall body 71 and a fourth inner wall body 72. The third inner wall body 71 is disposed around both a surface that is of the second sacrificial film 41 and that faces the second opening 42 and a surface that is of the auxiliary film 51 and that faces the third opening 52, and the third inner wall body 71 is L-shaped. The fourth inner wall body 72 is disposed on the third inner wall body 71, and is not directly in contact with the intrinsic base region 21.

For example, a material of the third inner wall body 71 is the same as a material of the first inner wall body 64. For example, the material of the third inner wall body 71 is SiO2. A material of the fourth inner wall body 72 is the same as a material of the second inner wall body 63. For example, the material of the fourth inner wall body 72 is Si3N4.

In some other embodiments, as shown in FIG. 3I(b), the formed second inner side wall 70 includes a third inner wall body 71. In other words, after the third inner wall body 71 and the fourth inner wall body 72 are prepared by using a same process as step S50, a step of removing the fourth inner wall body 72 is further included.

When the second inner side wall 70 includes only a single-layer inner wall body, an opening of the emitter region window is large, and the finally formed emitter region has a large area and small resistance.

After the first inner side wall 60 is formed, step S70 is performed, and when the collector region 19 is formed through ion implantation, ion implantation is performed on the first inner side wall 60, which affects effect of isolation between the extrinsic base region and the emitter region that are subsequently formed. Therefore, after the first inner side wall 60 is removed to form the second inner side wall 70 again, the foregoing problem can be resolved, and effect of isolation between the extrinsic base region and the emitter region can be improved. In addition, in a process of forming the first opening 32, a part that is of the first inner wall body 64 and that is in contact with the first sacrificial film 31 is synchronously removed, that is, a cross section of the first inner wall body 64 is strip-shaped. Consequently, the first inner wall body 64 cannot implement isolation in the region. The third inner wall body 71 included in the second inner wall body 70 that is formed again is L-shaped and has a wide coverage area, so that effect of isolation between the extrinsic base region and the emitter region can be improved.

S100: Clean a surface of the intrinsic base region 21.

For example, the surface of the intrinsic base region 21 may be cleaned through wet etching, to remove an intrinsic oxidized layer generated after the surface of the intrinsic base region 21 is oxidized.

After the intrinsic base region 21 is formed, step S90 is further performed. Consequently, an exposed surface of the intrinsic base region 21 is prone to be oxidized to generate SiO2, which affects electrical contact effect between the subsequently formed emitter region and the intrinsic base region 21, resulting in high resistance of the emitter region. The surface of the intrinsic base region 21 is cleaned, so that SiO2 on the surface of the intrinsic base region 21 can be removed. This improves the electrical contact effect between the subsequently formed emitter region and the intrinsic base region 21, facilitates epitaxy growth of a single crystal material in the emitter region, and effectively reduces resistance of the emitter region.

S110: Form, at the emitter region window, an emitter region film 81 that is in contact with the intrinsic base region 21, and pattern the emitter region film 81 and the auxiliary film 51, to form an emitter region 80 and an auxiliary layer 50, as shown in FIG. 3J-1, FIG. 3J-2, and FIG. 3J-3.

A material of the emitter region 80 may be, for example, doped epitaxial monocrystalline silicon or polycrystalline silicon, or in-situ doping may be performed on the emitter region 80, to enhance doping concentration.

In some embodiments, the semiconductor structure does not include a cap layer, or the cap layer is not synchronously formed with the emitter region 80. In this case, the forming an emitter region 80 includes:
forming the emitter region film 81, where the emitter region film 81 covers the auxiliary film 51 and the second inner side wall 70; and patterning the emitter region film 81, to form the emitter region 80.

When the emitter region film 81 is patterned, the auxiliary film 51 is synchronously patterned (remove a part that is of the auxiliary film 51 and that is not covered by the emitter region 80). In other words, the emitter region 80 and the auxiliary layer 50 are synchronously formed.

For example, the auxiliary film 51 may be patterned by using the photolithography and dry etching processes, to form the auxiliary layer 50.

In some other embodiments, as shown in FIG. 3J-1, FIG. 3J-2, and FIG. 3J-3, the emitter region 80 and a cap layer 90 are synchronously formed. In this case, the forming an emitter region 80 and an auxiliary layer 50 includes the following steps.

S111: Form the emitter region film 81 on the auxiliary film 51.

For example, the emitter region film 81 may be formed by using the epitaxial growth process. A material of the emitter region film 81 may be, for example, doped epitaxial monocrystalline silicon or polycrystalline silicon.

The emitter region film 81 may cover the auxiliary film 51, or may not cover the auxiliary film 51, provided that the emitter region film 81 is in contact with the intrinsic base region 21 by using the emitter region window.

S112: Form a cap film 91 on the emitter region film 81.

A material of the cap film 91 may be a dielectric material, and the material of the cap film 91 is, for example, silicone. For example, the material of the cap film 91 is silicon oxide, silicon nitride, silicon oxynitride, or oxygen-rich silicon dioxide.

For example, the cap film 91 may be formed by using the CVD process, and the cap film 91 covers the emitter region film 81.

S113: Pattern a film (for example, the auxiliary film 51, the emitter region film 81, and the cap film 91) on a side that is of the second sacrificial film 41 and that is away from the substrate 10, to form the auxiliary layer 50, the emitter region 80, and the cap layer 90.

For example, the auxiliary film 51, the emitter region film 81, and the cap film 91 are patterned by using the photolithography and etching processes, to expose the second sacrificial film 41.

The patterning of the auxiliary film 51, the emitter region film 81, and the cap film 91 may be completed in a plurality of processes, or may be completed in a same process. A specific pattern of a structure retained after the auxiliary film 51, the emitter region film 81, and the cap film 91 are patterned is not limited, and may be properly set based on a requirement.

The auxiliary layer 50 formed by patterning the auxiliary film 51, the emitter region film 81, and the cap film 91 is located between the emitter region 80 and the extrinsic base region 22, the emitter region 80 is in contact with the intrinsic base region 21 through an opening at the auxiliary layer 50, and the cap layer 90 covers a top surface of the emitter region 80.

S120: Form a first outer wall body 103 and a second outer wall body 104, as shown in FIG. 3K-1, FIG. 3K-2, and FIG. 3K-3.

The first outer wall body 103 is disposed between the second outer wall body 104 and the emitter region 80. The first outer wall body 103 and the second outer wall body 104 wrap at least a side surface of the emitter region 80.

In some embodiments, as shown in FIG. 3K-1, FIG. 3K-2, and FIG. 3K-3, the first outer wall body 103 and the second outer wall body 104 wrap side surfaces of the auxiliary layer 50, the emitter region 80, and the cap layer 90, and wrap a top surface of the cap layer 90.

As shown in FIG. 3K-1, FIG. 3K-2, and FIG. 3K-3, in some embodiments, a method for forming the first outer wall body 103 and the second outer wall body 104 includes the following steps.

S121: Form a third dielectric film 101 on the substrate 10 on which the cap layer 90 is formed.

A manner of forming the third dielectric film 101 may be, for example, forming the third dielectric film 101 by using the CVD process.

A material of the third dielectric film 101 may be a dielectric material, and the material of the third dielectric film 101 is, for example, silicone. For example, the material of the third dielectric film 101 is SiO2, Si3N4, silicon oxynitride, or oxygen-rich silicon dioxide.

In some embodiments, the material of the third dielectric film 101 is different from the material of the first sacrificial film 31. For example, the material of the third dielectric film 101 is Si3N4, and the material of the first sacrificial film 31 is SiO2.

In this way, when the first sacrificial film 31 is subsequently removed, the first outer side wall 103 formed by the third dielectric film 101 is not removed, to ensure that the outer side wall protects the emitter region 21.

S122: Form a fourth dielectric film 102 on the third dielectric film 101.

A manner of forming the fourth dielectric film 102 may be, for example, forming the fourth dielectric film 102 by using the CVD process.

A material of the fourth dielectric film 102 may be a dielectric material, and the material of the fourth dielectric film 102 is, for example, silicone. For example, the material of the fourth dielectric film 102 is SiO2, Si3N4, silicon oxynitride, or oxygen-rich silicon dioxide.

In some embodiments, the material of the fourth dielectric film 102 is different from the material of the second sacrificial film 41. For example, the material of the fourth dielectric film 102 is SiO2, and the material of the second sacrificial film 41 is Si3N4.

In this way, when the second sacrificial film 41 is subsequently removed, the second outer side wall 104 formed by the fourth dielectric film 102 is not removed, to protect the emitter region 21.

S123: Pattern the third dielectric film 101 and the fourth dielectric film 102, to form the first outer wall body 103 and the second outer wall body 104.

For example, the third dielectric film 101 and the fourth dielectric film 102 may be patterned by using the etching process, to form the first outer wall body 103 and the second outer wall body 104.

A process of patterning the third dielectric film 101 and the fourth dielectric film 102 may be completed in a same process, or may be separately completed in a plurality of processes.

S130: Remove the first sacrificial film 31 and the second sacrificial film 41, to form an extrinsic base region 22 at corresponding positions, as shown in FIG. 3L-1, FIG. 3L-2, FIG. 3L-3, FIG. 3L-4, and FIG. 3L-5.

In some embodiments, as shown in FIG. 3L-1, FIG. 3L-2, FIG. 3L-3, FIG. 3L-4, and FIG. 3L-5, a method for forming the extrinsic base region 22 includes the following steps.

S131: Remove the second sacrificial film 41.

For example, the second sacrificial film 41 may be removed by using the etching process. Two ends of the intrinsic base region 21 are exposed to function as a seed crystal for forming a baselink region 221.

S132: Form the baselink region 221 under the auxiliary layer 50.

For example, the baselink region 221 may be formed by using the selective epitaxy growth process.

A size of the baselink region 221 is not limited in embodiments of this application, provided that the baselink region 221 is in contact with the intrinsic base region 21. A structure of the baselink region 221 shown in FIG. 3K-1, FIG. 3K-2, and FIG. 3K-3 is merely an example, and is not limited.

A material of the baselink region 221 may include, for example, heavily doped monocrystalline silicon, and may further include a small quantity of polycrystalline silicon.

S133: Remove the first sacrificial film 31.

For example, the first sacrificial film 31 may be removed by using the etching process. The surface of the substrate 10 is exposed, and the auxiliary extrinsic base region 18 is exposed. The first sacrificial film 31 may be completely removed, or as shown in FIG. 3K-1, FIG. 3K-2, and FIG. 3K-3, a part of the first sacrificial film 31 is reserved and is not removed, and may be properly set based on a requirement.

When a material of the second outer wall body 104 is the same as the material of the first sacrificial film 31, when the first sacrificial film 31 is removed, the second outer wall body 104 is synchronously removed. The reserved first outer wall body 103 is used as an outer side wall 100 of the semiconductor structure, and the outer side wall 100 is configured to protect the emitter region 80.

S134: Form an extrinsic base region film 222 at a corresponding position of the first sacrificial film 31.

For example, the extrinsic base region film 222 may be formed at the corresponding position of the first sacrificial film 31 by using the selective epitaxy growth process. In other words, the extrinsic base region film 222 is formed on the surface of the substrate 10, and the extrinsic base region film 222 is in direct contact with the auxiliary extrinsic base region 18.

Thickness of the extrinsic base region film 222 may be the same as thickness of the first sacrificial film 31. Thickness of the extrinsic base region film 222 may alternatively be greater than thickness of the first sacrificial film 31.

A material of the extrinsic base region film 222 may be, for example, polycrystalline silicon or polycrystalline silicon silicide. In some embodiments, in-situ doping may further be performed on the extrinsic base region film 222.

The formed extrinsic base region film 222 may be in contact with the intrinsic base region 21, or may not be in contact with the intrinsic base region 21. In other words, an effective extrinsic base region 223 formed by using the extrinsic base region film 222 may be in contact with the intrinsic base region 21, or may not be in contact with the intrinsic base region 21.

S135: Pattern the extrinsic base region film 222, to form the effective extrinsic base region 223.

For example, the extrinsic base region film 222 may be patterned by using the photolithography and etching processes.

In some other embodiments, a method for forming the extrinsic base region 22 includes: The auxiliary extrinsic base region 18 functions as a seed layer of the extrinsic base region film 222, and the extrinsic base region 22 directly epitaxially grows on the auxiliary extrinsic base region 18. A dielectric protection layer covers the sinker region 14, to ensure that the extrinsic base region 22 epitaxially grows only on the auxiliary extrinsic base region 18, and a structure in S135 is directly obtained. This can save patterning steps such as photoetching and etching of the extrinsic base region.

In view of this, as shown in FIG. 3L-1, FIG. 3L-2, FIG. 3L-3, FIG. 3L-4, and FIG. 3L-5, the extrinsic base region 22 formed by using the foregoing method includes the effective extrinsic base region 223 and the baselink region 221, the effective extrinsic base region 223 is in contact with the baselink region 221, and the baselink region 221 is in contact with the intrinsic base region 21, to realize contact between the extrinsic base region 22 and the intrinsic base region 21. The material of the baselink region 221 is quasi-single-crystalline silicon, and an activation rate of a doped ion of the baselink region is greater than that of a doped ion of the effective extrinsic base region 223 (a material is polycrystalline silicon). Therefore, contact between the effective extrinsic base region 223 and the intrinsic base region 21 is implemented by using the baselink region 221, to reduce contact resistance between the extrinsic base region 22 and the intrinsic base region 21.

In addition, when the auxiliary extrinsic base region 18 is further disposed in the substrate 10, as shown in FIG. 3L-1, FIG. 3L-2, FIG. 3L-3, FIG. 3L-4, and FIG. 3L-5, the effective extrinsic base region 223 is in contact with the auxiliary extrinsic base region 18 on the surface of the substrate 10. That the effective extrinsic base region 223 is in contact with the auxiliary extrinsic base region 18 is equivalent to increasing thickness of the effective extrinsic base region 223. This may raise the extrinsic base region 22, to reduce resistance of the extrinsic base region 22.

In some other embodiments, as shown in FIG. 3M-1, FIG. 3M-2, FIG. 3M-3, and FIG. 3M-4, a method for forming the extrinsic base region 22 includes the following steps.

S131': Remove the second sacrificial film 41.

S132': Remove the first sacrificial film 31.

It is clear that a process of removing the second sacrificial film 41 and a process of removing the first sacrificial film 31 may be completed in a same process, or may be completed in different processes.

S133': Form the extrinsic base region film 222 at corresponding positions of the first sacrificial film 31 and the second sacrificial film 41.

S134': Pattern the extrinsic base region film 222, to form the extrinsic base region 22.

As shown in FIG. 3M-1, FIG. 3M-2, FIG. 3M-3, and FIG. 3M-4, the formed extrinsic base region 22 is directly linked to the intrinsic base region 21, and the extrinsic base region 22 is in contact with the auxiliary extrinsic base region 18 on the surface of the substrate 10. This may raise the extrinsic base region 22, to reduce the resistance of the extrinsic base region 22.

S140: Perform heat treatment on the semiconductor structure.

Heat treatment (for example, annealing) is performed on a structure obtained in FIG. 3L-1, FIG. 3L-2, FIG. 3L-3, FIG. 3L-4, and FIG. 3L-5 or FIG. 3M-1, FIG. 3M-2, FIG. 3M-3, and FIG. 3M-4, and doping distribution in the emitter region 80, the intrinsic base region 21, the extrinsic base region 22, and the collector region 19 is adjusted, to activate doping ions.

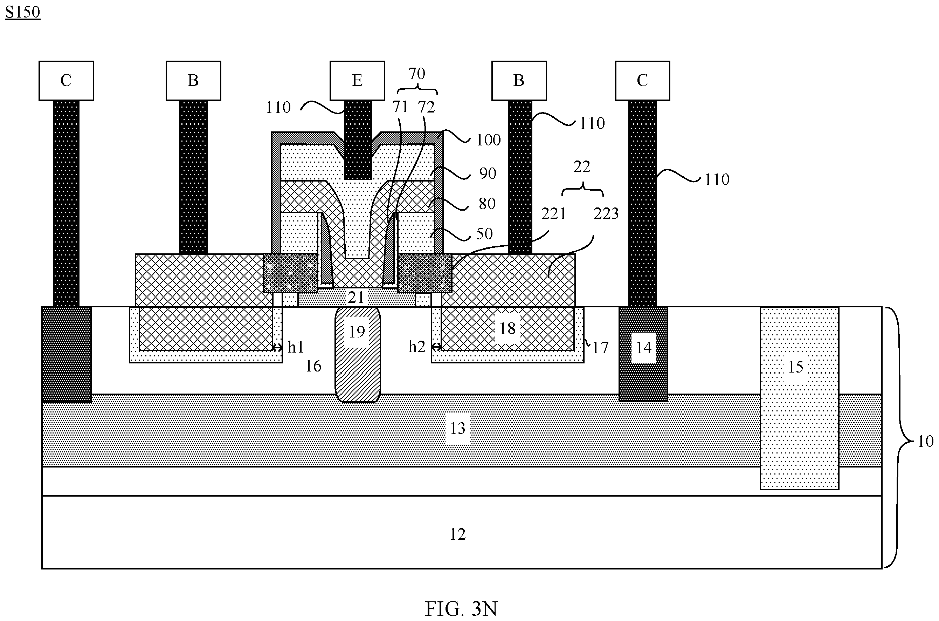

S150: Extract an emitter electrode (emitter electrode, E) from the emitter region 80, extract a base electrode (base electrode, B) from the extrinsic base region 22, and extract a collector electrode (collector electrode, C) from the collector region 19 through a connection hole (contact) 110, as shown in FIG. 3N.

The emitter electrode E is in contact with the emitter region 80 through the connection hole 110 disposed on the surface of the emitter region 80. The base electrode B is in contact with the extrinsic base region 22 through the connection hole 110 disposed on the surface of the extrinsic base region 22. The sinker region 14 is in contact with the collector region 19 by using the buried collector region 13, and the collector electrode C is in contact with the sinker region 14 through the connection hole 110 disposed on a surface of the sinker region 14, so that the collector electrode C is in contact with the collector region 19.

It should be noted that the preparation method for a semiconductor structure provided in embodiments of this application is not limited to the foregoing steps, and another step may be added or some of the foregoing steps may be removed based on a requirement. In addition, a sequence of steps in the preparation method is merely an example, and may be adjusted based on a requirement.

In view of this, as shown in FIG. 3N, an embodiment of this application provides a semiconductor structure. The semiconductor structure includes the substrate 10, and the intrinsic base region 21, the extrinsic base region 22, the auxiliary layer 50, the emitter region 80, the cap layer 90, the outer side wall 100, the emitter electrode E, the base electrode B, and the collector electrode C that are disposed on the substrate 10.

The substrate 10 includes the buried collector region 13, the sinker region 14, the third isolation structure 15, the active region 16, the first isolation structure 17, the auxiliary extrinsic base region 18, and the collector region 19.

The collector region 13 is buried in the substrate 10, and a surface of the collector region 13 is flush with the surface of the substrate 10. The collector region 13 is disposed under the intrinsic base region 21. For example, the collector region 13 is located in the active region 16 under the intrinsic base region 21.

The sinker region 14 is located on a side that is of the first isolation structure 17 and that is away from the collector region 19, the sinker region 14 and the first isolation structure 17 are located on the buried collector region 13, and both the sinker region 14 and the collector region 19 are in contact with the buried collector region 13.

The third isolation structure 15 is located on a side that is of the sinker region 14 and that is away from the collector region 14. The third isolation structure 15 may be a shallow trench isolation structure or a deep trench isolation structure, and may be properly disposed based on a requirement. It is clear that if the third isolation structure 15 does not need to be formed, the third isolation structure 15 may not be formed on the substrate 10.

The material of the third isolation structure 15 may be, for example, SiO2+polycrystalline silicon.

The auxiliary extrinsic base region 18 is disposed under the extrinsic base region 22, and the surface of the auxiliary extrinsic base region 18 is used as a part of the surface of the substrate 10. Alternatively, it is understood as that the first isolation structure 17 has a groove (for example, may be a groove enclosed by the first isolation structure 17), and the auxiliary extrinsic base region 18 is located in the groove. In visual effect, this is equivalent to burying both the first isolation structure 17 and the auxiliary extrinsic base region 18 in the substrate 10.

The first isolation structure 17 wraps the side surface and the bottom surface of the auxiliary extrinsic base region 18, the first isolation structure 17 is buried in the substrate 10, and a part of the surface of the first isolation structure 17 is used as a part of the surface of the substrate 10. Alternatively, it is understood as that the substrate 10 has a groove, and the first isolation structure 17 is located in the groove.

At least parts (that are located in auxiliary extrinsic base regions 18 and that are close to the collector region 19) that are of first isolation structures 17 and that are located between the collector region 19 and the auxiliary extrinsic base regions 18 have equal thickness.

In other words, in a sectional view of the semiconductor structure shown in FIG. 3N, thickness h1 of a part that is of the first isolation structure 17 and that is at least located between the collector region 19 and a left auxiliary extrinsic base region 18 is equal to thickness h2 of a part that is of the first isolation structure 17 and that is located between the collector region 19 and a right auxiliary extrinsic base region 18.

In some embodiments, as shown in FIG. 3N, thickness of the first isolation structure 17 is the same at all positions.

In some other embodiments, as shown in FIG. 4A, parts that are of the first isolation structures 17 and that are located between the collector region 19 and the auxiliary extrinsic base regions 18 have equal thickness. Thickness of remaining parts of the first isolation structures 17 may be the same as or different from the thickness of the parts that are of the first isolation structures 17 and that are located between the collector region 19 and the auxiliary extrinsic base regions 18.

The material of the first isolation structure 17 may be, for example, SiO2 or SiO2+Si3N4.

In some embodiments, the auxiliary extrinsic base region 18 is disposed under the extrinsic base region 22. However, as shown in FIG. 4B, the auxiliary extrinsic base region 18 is not disposed around the collector region 19.

In other words, the extrinsic base region 22 is disposed on a periphery of the intrinsic base region 21, for example, disposed around the intrinsic base region 21. However, the auxiliary extrinsic base region 18 is not disposed around the collector region 19, and the auxiliary extrinsic base region 18 is disposed only under a part of the extrinsic base region 22. For example, the auxiliary extrinsic base regions 18 are disposed on two opposite sides of the collector region 19.

In some other embodiments, the auxiliary extrinsic base region 18 is disposed under the extrinsic base region 22, and the auxiliary extrinsic base region 18 is disposed around the collector region 19, as shown in FIG. 4C. A pattern of the auxiliary extrinsic base region 18 is not limited in embodiments of this application. FIG. 4B and FIG. 4C are merely examples, and does not constitute any limitation.

The collector region 19 is buried in the substrate 10, and the surface of the collector region 18 is flush with the surface of the substrate 10. Alternatively, it is understood as that the surface of the collector region 18 is used as a part of the surface of the substrate 10. The collector region 18 is located under the intrinsic base region 21, and is directly opposite to the emitter region window.

The intrinsic base region 21 is disposed on the surface of the substrate 10, and is in contact with the collector region 19 on the surface of the substrate 10, to form a collector-base junction (C-B). The material of the intrinsic base region 21 may be, for example, SiGe or SiGe:C.

The extrinsic base region 22 is disposed on the surface of the substrate 10, and is in contact with the auxiliary extrinsic base region 18 on the surface of the substrate 10. The extrinsic base region 22 is disposed on the periphery of the intrinsic base region 21, and is in contact with the intrinsic base region 21. A material of the extrinsic base region 22 may be, for example, polycrystalline silicon.

Structures of prepared extrinsic base regions 22 are different by using the foregoing different methods.

In some embodiments, in the process of preparing the semiconductor structure, step S131 to step S13 5 are performed, to form the extrinsic base region 22.

As shown in FIG. 4A, the extrinsic base region 22 includes the baselink region 221 and the effective extrinsic base region 223, and the baselink region 221 is in contact with both the intrinsic base region 21 and the effective extrinsic base region 223.

The material of the baselink region 221 may be quasi-single-crystalline silicon, and a material of the effective extrinsic base region 223 may be polycrystalline silicon. The activation rate of the doped ion of the baselink region 221 is greater than that of the doped ion of the effective extrinsic base region 223.

In some embodiments, as shown in FIG. 4A, the baselink region 221 is linked to the intrinsic base region 21, and the baselink region 221 is linked to the effective extrinsic base region 223.

In some other embodiments, the baselink region 221 is disposed on the intrinsic base region 21, and the baselink region 221 is joined with the effective extrinsic base region 223.

The baselink region 221 is in contact with the intrinsic base region 21 and the effective extrinsic base region 223 in different manners based on different structures of the baselink region 221. The foregoing is merely an example, and does not constitute any limitation.

In addition, as shown in FIG. 4A, the effective extrinsic base region 223 may not be in contact with the intrinsic base region 21. It is clear that the effective extrinsic base region 223 may alternatively be in contact with the intrinsic base region 21.

In some other embodiments, in the process of preparing the semiconductor structure, step S 13 1' to step S134' are performed, to form the extrinsic base region 22.

As shown in FIG. 5, the extrinsic base region 22 does not include the baselink region, and materials of all parts of the extrinsic base region 22 are the same.

The auxiliary layer 50 has an opening, and the auxiliary layer 50 is disposed on the extrinsic base region 22. The opening at the auxiliary layer 50 may be understood as the third opening 52 on the auxiliary film 51 in the foregoing preparation process. A material of the auxiliary layer 50 may be, for example, SiO2.

The emitter region 80 is disposed at the auxiliary layer 50, and is in contact with the intrinsic base region 21 through the opening at the auxiliary layer 50, to form an emitter-base junction (E-B). The material of the emitter region 80 may be, for example, doped epitaxial monocrystalline silicon or polycrystalline silicon.

An inner side wall is disposed between the extrinsic base region 22 and the emitter region 80, may further extend between the auxiliary layer 50 and the emitter region 80, and is configured to isolate the extrinsic base region 22 from the emitter region 80.

In some embodiments, in the process of preparing the semiconductor structure, step S90 is performed. In this case, the inner side wall in the semiconductor structure may be the second inner side wall 70.

It is clear that the second inner side wall 70 may include the third inner wall body 71 and the fourth inner wall body 72. The second inner wall body 70 may alternatively include only the third inner wall body 71. In either case, the inner side wall includes an L-shaped part (the third inner wall body 71). For example, the material of the third inner wall body 71 may be SiO2. For example, the material of the fourth inner wall body 72 may be Si3N4.

In some other embodiments, in the process of preparing the semiconductor structure, step S90 is not performed. In this case, the inner side wall in the semiconductor structure may be the first inner side wall 60.

It is clear that the first inner side wall 60 may include the first inner wall body 64 and the second inner wall body 63. The first inner side wall 60 may alternatively include only the first inner wall body 64. For example, the material of the first inner wall body 64 may be SiO2. For example, the material of the second inner wall body 63 may be Si3N4.

The cap layer 90 covers a surface that is of the emitter region 80 and that is away from the substrate 10, and is configured to protect the emitter region 80. A material of the cap layer 90 may be, for example, SiO2.

The outer side wall 100 at least wraps the side surface of the emitter region 80, to protect the emitter region 80. The outer side wall 100 may be the first outer wall body 103 in the foregoing preparation process. A material of the outer side wall 100 may be, for example, Si3N4.

The collector electrode C is in contact with the collector region 19 through the connection hole 110 that is in contact with the sinker region 14 and through the sinker region 14 and the buried collector region 13. The connection hole 110 may be directly disposed on the surface of the sinker region 14. A metal silicide layer may alternatively be disposed between the connection hole 110 and the sinker region 14, to implement contact between the connection hole 110 and the sinker region 14.

The emitter electrode E is in contact with the emitter region 80 through the connection hole 110 that passes through the cap layer 90 and is in contact with the emitter region 80. The connection hole 110 may be directly disposed on the surface of the emitter region 80. A metal silicide layer may alternatively be disposed between the connection hole 110 and the emitter region 80, to implement contact between the connection hole 110 and the emitter region 80.

The base electrode B is in contact with the extrinsic base region 22 through the connection hole 110 that is in contact with the extrinsic base region 22. The connection hole 110 may be directly disposed on the surface of the extrinsic base region 22. A metal silicide layer may alternatively be disposed between the connection hole 110 and the extrinsic base region 22, to implement contact between the connection hole 110 and the extrinsic base region 22.

It should be understood that, when the emitter region 80, the extrinsic base region 22, and the sinker region 14 are covered with a dielectric layer, the connection hole 110 inevitably passes through the dielectric layer.

An NPN-type HBT device is used as an example. The emitter electrode E is configured to emit electrons. The base electrode B is configured to control the electrons (so that a current flowing to the collector electrode C is controlled by an input signal of the base electrode B). The collector electrode C is configured to collect the electrons.

It should be noted that a SiGe HBT transistor in the foregoing semiconductor structure may be an NPN-type transistor (the intrinsic base region 21 is a P region, that is, the semiconductor is a P-type semiconductor; and both the emitter region 80 and the collector region 19 are N regions, that is, the semiconductor is an N-type semiconductor), or a PNP-type transistor (the intrinsic base region 21 is an N region, that is, the semiconductor is an N-type semiconductor; and both the emitter region 80 and the collector region 19 are P regions, that is, the semiconductor is a P-type semiconductor).

In addition, structures, locations, and quantities of the emitter electrode E, the base electrode B, and the collector electrode C that are shown in the schematic diagrams in embodiments of this application are merely examples. There may be only one emitter electrode E, one base electrode B, and one collector electrode C, or there may be one base electrode B and one collector electrode C each on a left side and a right side of the emitter electrode E.

The materials of the film layers in the semiconductor structure are merely examples, and do not constitute any limitation.

The NPN-type HBT device is used as an example to describe a working principle of the SiGe HBT device provided in embodiments of this application. A power supply is applied to an emitter-base junction, the emitter-base junction is forward biased, and a majority of carriers (free electrons) in the emitter region 80 continuously cross the emitter-base junction and enter the intrinsic base region 21, to form an emitter electrode current. After entering the intrinsic base region 21, the electrons first accumulate near the emitter-base junction, and an electron concentration difference is gradually formed. Under effect of the concentration difference, an electronic flow is driven to diffuse toward the collector-base junction in the intrinsic base region 21, and is pulled into the collector region 19 by an electric field of the collector-base junction, to form a collector electrode current. A small part of electrons (because the intrinsic base region 21 is very thin) are combined with holes in the intrinsic base region 21, and a ratio of a diffused electron flow to a combined electron flow determines an amplification capability of a triode. Because a reverse voltage applied to the collector-base junction is very large, electric field force generated by the reverse voltage prevents electrons in the collector region 19 from diffusing into the intrinsic base region 21, and pulls the electrons that are diffused near the collector-base junction into the collector region 19, to form a main collector electrode current. In addition, a minority of carriers (holes) in the collector region 19 also drift, and flow toward the intrinsic base region 21, to form a reverse saturation current.

According to the preparation method for a semiconductor structure provided in embodiments of this application, the groove is first formed on the base 11, and then the isolation film 171 is formed in the groove. The isolation film 171 is patterned, to prepare the first isolation structure 17. In this way, when a process error is not considered, film thickness of a finally formed first isolation structure 17 is the same at all positions. Due to a process factor, there may be a deviation of several nanometers. However, in the photoetching and etching processes, the thickness of the parts (parts that are of the first isolation structures 17, that are located in the auxiliary extrinsic base regions 18, and that are close to the collector region 19) that are of the first isolation structures 17 and that are located between the collector region 19 and the auxiliary extrinsic base regions 18 may have a deviation of dozens of nanometers. Therefore, according to embodiments of this application, it can be ensured that the parts that are of the first isolation structures 17 and that are located between the collector region 19 and the auxiliary extrinsic base regions 18 have equal thickness (h1 and h2 in the sectional view in FIG. 4A). Therefore, according to the formula C=εS/d (ε is a dielectric constant, S is an area in which plates are directly opposite to each other, and d is a distance between the plates) of parasitic capacitance, it can be learned that when materials (which affect ε) of the first isolation structures 17 on both sides of the collector region 19 and an area (which affects S) in which the auxiliary extrinsic base region 18 and the collector region 19 are directly opposite to each other are fixed, the parts that are of the first isolation structures 17 and that are located between the collector region 19 and the auxiliary extrinsic base regions 18 have equal thickness (which affects d). This can improve symmetry of parasitic collector-base junction capacitance on both sides of a central line. Therefore, a current can be evenly distributed on both sides of the central line, and device performance (for example, a maximum oscillation frequency) is optimal. In addition, in embodiments of this application, preparation of each film layer may be implemented by using the conventional technology. The collector region 19 is also formed by defining a position by using a self-aligned structure and then performing ion implantation on the substrate 10.

In addition, both the intrinsic base region 21 and the extrinsic base region 22 are disposed on the surface of the substrate 10, the collector region 19 is disposed inside the substrate 10, and there is no raised epitaxial collector region. Therefore, the intrinsic base region 21 and the extrinsic base region 22 are directly formed on the surface of the known substrate 10, and whether the intrinsic base region 21 is in contact with the extrinsic base region 22 is directly controlled by preparation processes of the intrinsic base region and the extrinsic base region. In comparison with the intrinsic base region disposed on the epitaxial collector region that is disposed on the surface of the substrate 10, the intrinsic base region 21 and the extrinsic base region 22 are directly disposed on the surface of the substrate 10 in embodiments of this application. In this case, contact between the intrinsic base region 21 and the extrinsic base region 22 is not affected due to a parameter like thickness of the raised epitaxial collector region. This can improve a contact yield between the intrinsic base region 21 and the extrinsic base region 22, and further improve a yield of the semiconductor structure. In addition, impact of the thickness of the collector region 19 on effect of the contact between the intrinsic base region 21 and the extrinsic base region 22 does not need to be considered. Therefore, this can reduce a requirement for process accuracy of manufacturing the collector region 19, and reduce a process difficulty. In addition, the collector region 19 is obtained through doping, and an epitaxy growth process (for preparing the collector region 19) is not needed, to save processing costs. In addition, the auxiliary extrinsic base region 18 is buried in the substrate 10 in advance, and after the auxiliary extrinsic base region 18 is in contact with the extrinsic base region 22, thickening of the extrinsic base region 22 is implemented, to reduce resistance of the extrinsic base region 22.

In some embodiments, the semiconductor structure further includes a complementary metal-oxide-semiconductor field-effect transistor (complementary metal-oxide-semiconductor field-effect transistor, CMOSFET).

As shown in FIG. 2A and FIG. 2B, the preparation method for a semiconductor structure further includes the following steps.

S160: Form the CMOSFET on the base 11, as shown in FIG. 6.

The step of forming the CMOSFET on the base 11 may be performed before step S10, or may be performed after step S150.

As shown in FIG. 6, the third isolation structure 15 in the substrate 10 isolates a SiGe HBT structure from a CMOSFET structure. In this case, the third isolation structure 15 is a deep trench isolation structure.

In addition, the CMOSFET structure is not limited in embodiments of this application. The CMOSFET in FIG. 6 is merely an example. The CMOSFET may be an NMOS transistor or a PMOS transistor.

In this way, the semiconductor structure prepared by using the preparation method for a semiconductor structure is a CMOS+SiGe HBT device, and the CMOS and the SiGe HBT may be integrated on a same semiconductor structure, so that the semiconductor structure has advantages of the CMOS and the SiGe HBT.

### Example 2

A main difference between the example 2 and the example 1 lies in that, on the basis that the substrate 10 includes the first isolation structure 17, the substrate 10 further includes the second isolation structure 20.

As shown in FIG. 7, the semiconductor structure includes the substrate 10, and the intrinsic base region 21, the extrinsic base region 22, the auxiliary layer 50, the emitter region 80, the cap layer 90, the outer side wall 100, the emitter electrode E, the base electrode B, and the collector electrode C that are disposed on the substrate 10.

The intrinsic base region 21, the extrinsic base region 22, the auxiliary layer 50, the emitter region 80, the cap layer 90, the outer side wall 100, the emitter electrode E, the base electrode B, and the collector electrode C are the same as those in the example 1. For details, refer to the related descriptions in the example 1. Details are not described herein again.

As shown in FIG. 7, the substrate 10 includes the buried collector region 13, the sinker region 14, the third isolation structure 15, the active region 16, the first isolation structure 17, the auxiliary extrinsic base region 18, the collector region 19, and the second isolation structure 20.

The buried collector region 13, the sinker region 14, the third isolation structure 15, the active region 16, the first isolation structure 17, the auxiliary extrinsic base region 18, and the collector region 19 are the same as those in the example 1. For details, refer to the related descriptions in the example 1. Details are not described herein again.

As shown in FIG. 7, the second isolation structure 20 is located under (on a side away from the auxiliary extrinsic base region 18) the first isolation structure 17, and is in contact with the first isolation structure 17.

In some embodiments, as shown in FIG. 8, a projection of the first isolation structure 17 on the substrate 10 covers a projection of the second isolation structure 20 on the substrate 10.

In addition, the first isolation structure 17 covers the second isolation structure 20 in a direction perpendicular to the substrate 10.

For example, a maximum cross-sectional area of the second isolation structure 20 is less than a cross-sectional area of the auxiliary extrinsic base region 18. Alternatively, it is understood as that a projection of the auxiliary extrinsic base region 18 on the substrate 10 falls within an orthographic projection of the second isolation structure 20 on the substrate 10.

Both the first isolation structure 17 and the second isolation structure 20 are formed by filling the groove with a dielectric material. The first isolation structure 17 covers the second isolation structure 20, that is, a groove for placing the second isolation structure 20 is smaller than a groove for placing the first isolation structure 17. In this case, the small groove is formed first, and then the large groove is formed. Therefore, a process has a low difficulty, and is easy to implementation.

In some embodiments, the material of the second isolation structure 20 is the same as the material of the first isolation structure 17. For example, the material of the second isolation structure 20 is SiO2.

It can be learned from the foregoing descriptions that the semiconductor structure provided in this example is different from the substrate 10 of the semiconductor structure provided in the example 1, and preparation methods in the two examples are also slightly different.

In view of this, an embodiment of this application further provides a preparation method for a semiconductor structure. The method includes the following steps.

S10: Form the base 11.

In some embodiments, a method for forming the base 11 includes the following steps.

S11: Form an epitaxial layer on the silicon substrate 12, and perform ion implantation on the epitaxial layer, to form the buried collector region 13 and the sinker region 14, as shown in FIG. 9A-1, FIG. 9A-2, and FIG. 9A-3.

S12: Form a silicon dioxide (SiO2) film and a silicon nitride (Si3N4) film at the epitaxial layer.

S13: Form a third isolation trench at the epitaxial layer.

S14: Oxidize and repair a surface of the third isolation trench, to form a silicon dioxide interface.

S15: Fill the third isolation trench with a dielectric material, to form a filling layer.

S16: Process the filling layer, to form the third isolation structure 15.

For example, the third isolation structure 15 is a deep trench isolation structure.

S17': Form a second isolation trench at the epitaxial layer, as shown in FIG. 9B-1, FIG. 9B-2, and FIG. 9B-3.

It should be noted that, as shown in FIG. 9B-1, FIG. 9B-2, and FIG. 9B-3, when the second isolation trench is formed at the epitaxial layer, the SiO2 film and the Si3N4 film need to be formed at the epitaxial layer.

The SiO2 film and the Si3N4 film may be a SiO2 film and a Si3N4 film that are formed again after the third isolation structure 15 is formed (step S16 is performed), and then the SiO2 film and the Si3N4 film at the epitaxial layer are removed. This can ensure surface flatness of the SiO2 film and the Si3N4 film, and further improve process precision.

The SiO2 film and the Si3N4 film may alternatively be the SiO2 film and a Si3N4 film that is formed again after the third isolation structure 15 is formed (step S16 is performed), and then the Si3N4 film at the epitaxial layer is removed. This can ensure surface flatness of the Si3N4 film, and further improve process precision.

After the third isolation structure 15 is formed (step S16 is performed), and then the SiO2 film the Si3N4 film at the epitaxial layer are not removed, and may directly be used as the SiO2 film and the Si3N4 film that are required in this step. In other words, the SiO2 film and the Si3N4 film that are formed in step S12 are directly used as the SiO2 film and the Si3N4 film that are required in this step.

S18': Oxidize and repair a surface of the second isolation trench.

S19': Fill the second isolation trench with a dielectric material, to form a filling layer.

S19-1': Process the filling layer, to form the shallow trench isolation region 201.

S19-2': Remove the Si3N4 film.

S19-3': Remove the SiO2 film, to form the base 11.

It should be noted that there is no sequence between forming the third isolation structure 15 (steps S11 to S16) and forming the shallow trench isolation region 201 (steps S17' to S19-3'). The third isolation structure 15 may be formed first, or the shallow trench isolation region 201 may be formed first.

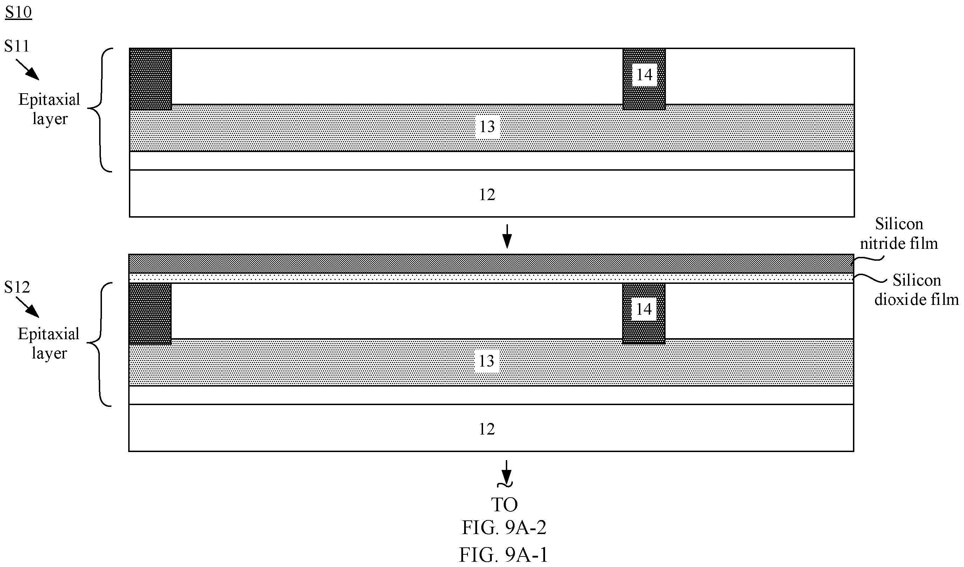

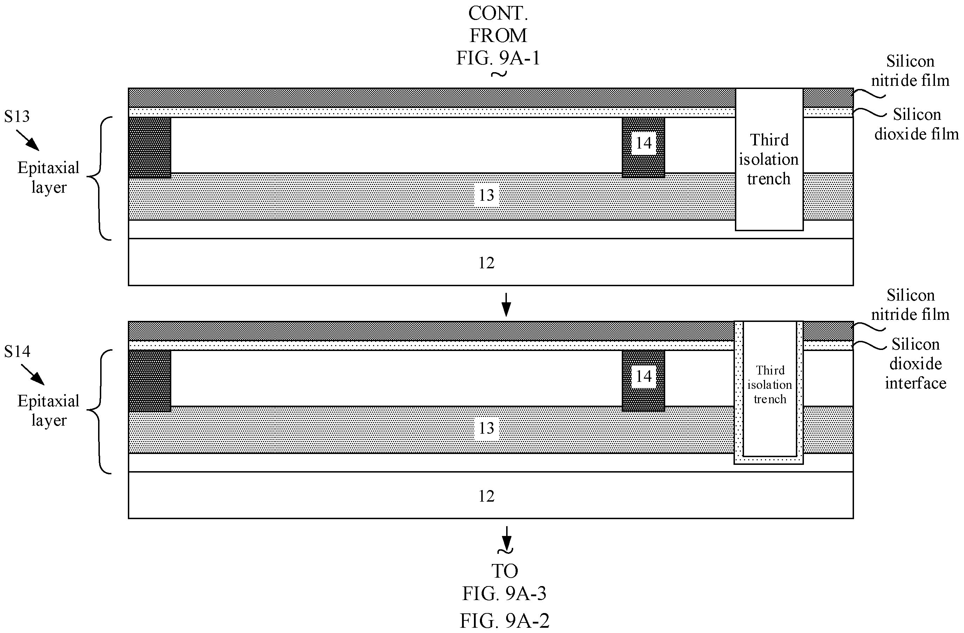

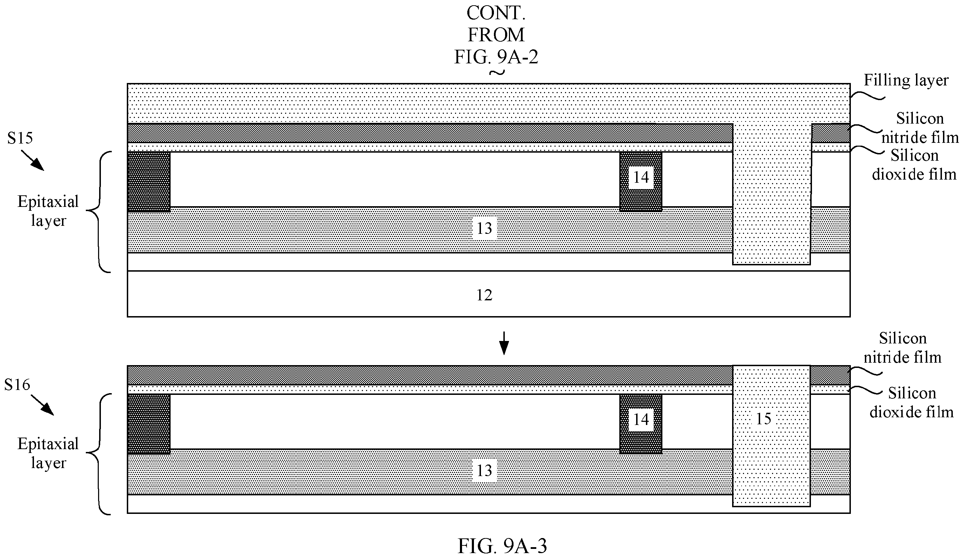

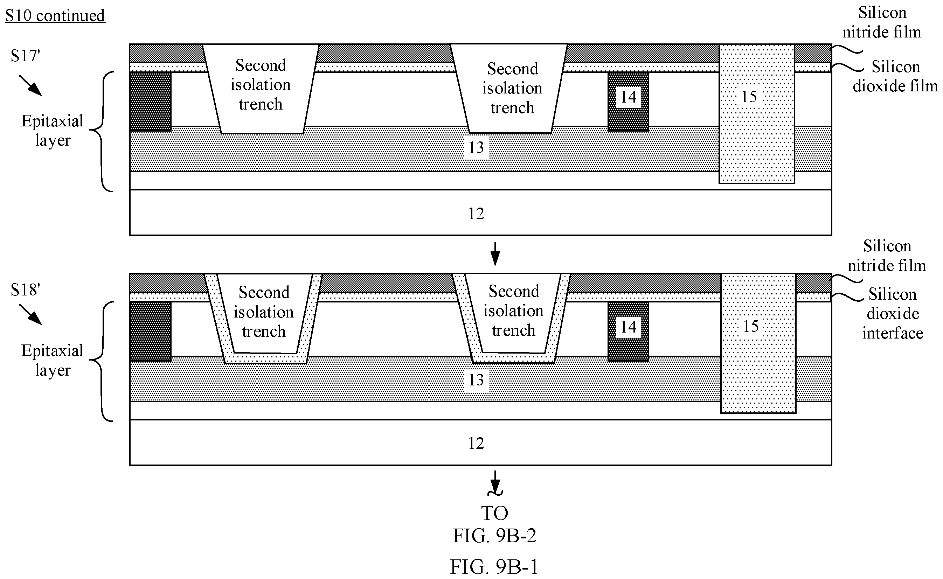

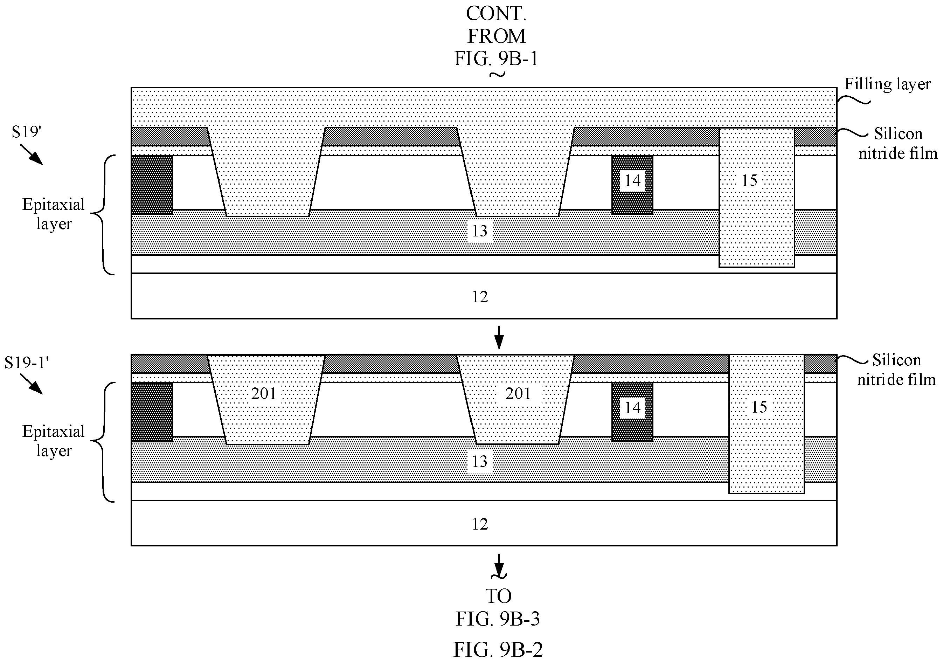

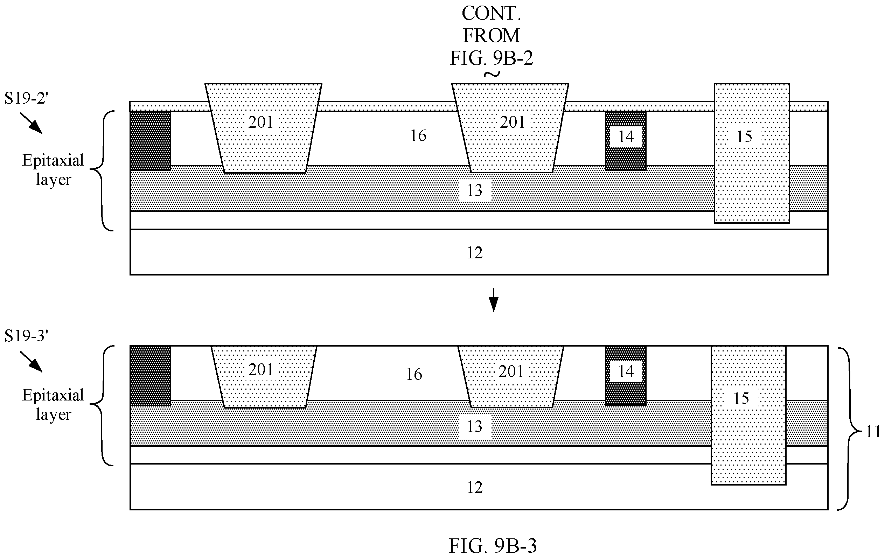

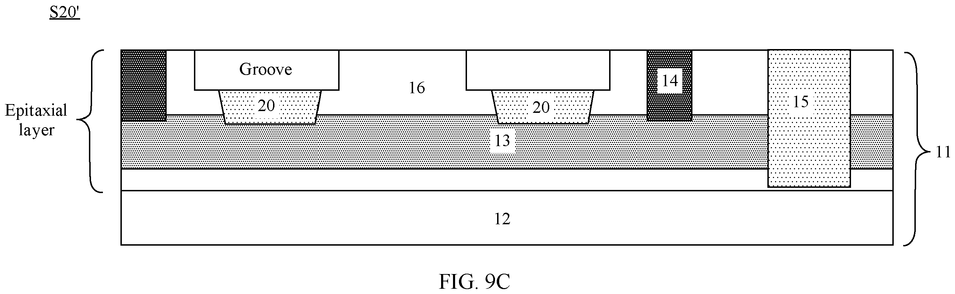

S20': Form a groove in the shallow trench isolation region 201 of the base 11, as shown in FIG. 9C.

A part of the shallow trench isolation region and a part of an active region at a periphery of the shallow trench isolation region are removed, to form the groove, and the shallow trench isolation region, under the groove, that is not removed is used as a second isolation structure of the semiconductor structure.

An area of a bottom of the groove is greater than a maximum cross-sectional area of the shallow trench isolation region 201, so that the shallow trench isolation region 201 at a position where the groove is formed is completely etched, and a part of the active region 16 is etched. In other words, a periphery of the groove is directly the active region 16.

In other words, in this example, the groove configured to accommodate the first isolation structure 17 is not located in the shallow trench isolation region 201. Instead, the shallow trench isolation region 201 is patterned, a part that is of the shallow trench isolation region 201 and that is away from the buried collector region 13 is directly removed, and a part of the active region 16 at the periphery of the shallow trench isolation region 201 is also removed, to form the groove. The shallow trench isolation region 201, under the groove, that is not removed is used as the second isolation structure 20 of the semiconductor structure.

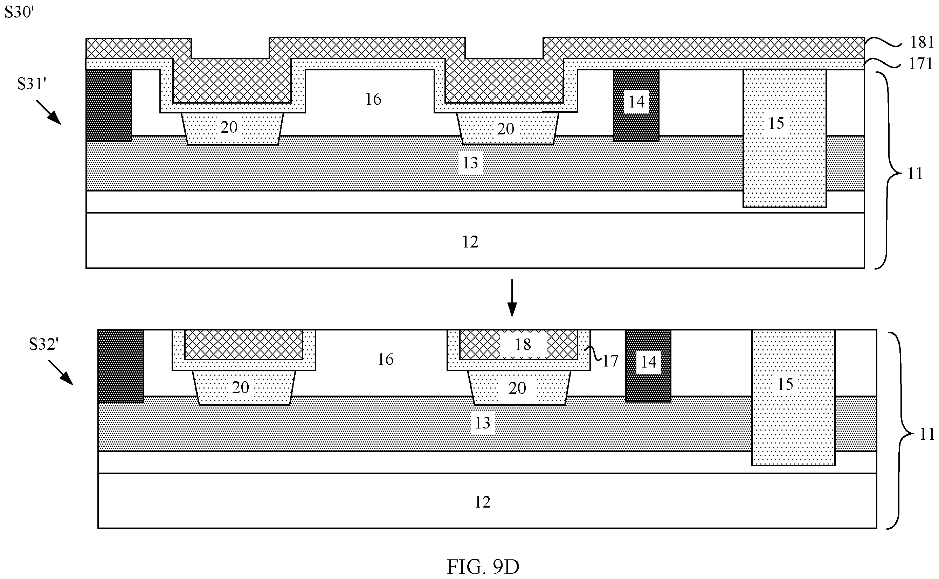

S30': Form the first isolation structure 17 and the auxiliary extrinsic base region 18, as shown in FIG. 9D.

The first isolation structure 17 is located on the second isolation structure 20, and is in contact with the second isolation structure 20.

S40 to S 160 are the same as those in the example 1. For details, refer to the foregoing related descriptions. In some embodiments, when S160 is not performed, a prepared semiconductor structure is shown in FIG. 8. In some embodiments, when S 160 is performed, a prepared semiconductor structure is shown in FIG. 10.

The second isolation structure 20 is disposed under the first isolation structure 17, to change a dielectric constant between the auxiliary extrinsic base region 18 and a buried collector region 13. This can reduce parasitic capacitance of the collector region 19 and the extrinsic base region, and improve device performance.

After the semiconductor structure prepared by using the preparation method provided in embodiments of this application is applied to a transistor circuit, the transistor circuit may be directly packaged by using a package body, to form a packaged device (for example, a chip); or may be packaged together with another chip, to form a packaged device. This is not limited in embodiments of this application.

In view of this, in some embodiments, the transistor circuit including any one of the foregoing semiconductor structures may be used in a radio frequency circuit.

The radio frequency circuit may be, for example, a power amplifier (power amplifier, PA), a variable gain amplifier (variable gain amplifier, VGA), a low noise amplifier (low noise amplifier, LNA), a transimpedance amplifier (trans-impedance amplifier, TIA), a driver (driver), a frequency mixer, or a clock data recovery (clock data recovery, CDR) circuit.

It is clear that an application scope of the radio frequency circuit including the foregoing semiconductor structure is not limited in embodiments of this application. For example, the radio frequency circuit may be used in communication apparatuses such as a microwave system, a photoelectric system, a radar, a wireless communication module, a router, a terminal, and a network device. The communication apparatus further includes a processor, and the processor is used by the radio frequency circuit to transmit a signal. The processor may be, for example, a central processing unit (central processing unit, CPU).

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A semiconductor structure, comprising:
a substrate, comprising a collector region, a first isolation structure, and an auxiliary extrinsic base region that are buried in the substrate;
an intrinsic base region, disposed on a surface of the substrate;
an extrinsic base region, disposed on the surface of the substrate, located at a periphery of the intrinsic base region, and in contact with the intrinsic base region; and
an emitter region, disposed on a side that is of the intrinsic base region and that is away from the substrate, and in contact with the intrinsic base region, wherein
the collector region is disposed under the intrinsic base region and is in contact with the intrinsic base region on the surface of the substrate, the auxiliary extrinsic base region is disposed under the extrinsic base region and is in contact with the extrinsic base region on the surface of the substrate, the first isolation structure wraps a side surface and a bottom surface of the auxiliary extrinsic base region, and parts that are of first isolation structures, that are located in auxiliary extrinsic base regions, and that are close to the collector region have equal thickness.

2. The semiconductor structure according to claim 1, wherein thickness of the first isolation structure is the same at all positions.

3. The semiconductor structure according to claim 1 or 2, wherein the substrate further comprises a second isolation structure; and
the second isolation structure is located under the first isolation structure, and is in contact with the first isolation structure.

4. The semiconductor structure according to claim 3, wherein a projection of the first isolation structure on the substrate covers a projection of the second isolation structure on the substrate.

5. The semiconductor structure according to any one of claims 1 to 4, wherein the extrinsic base region comprises a baselink region and an effective extrinsic base region; and
the baselink region is in contact with both the intrinsic base region and the effective extrinsic base region, a material of the baselink region comprises quasi-single-crystalline silicon, and a material of the effective extrinsic base region comprises polycrystalline silicon.

6. The semiconductor structure according to claim 5, wherein the baselink region is linked to the intrinsic base region and/or the effective extrinsic base region.

7. The semiconductor structure according to any one of claims 1 to 6, wherein the semiconductor structure further comprises an auxiliary layer; and
the auxiliary layer is disposed between the extrinsic base region and the emitter region, and the emitter region is in contact with the intrinsic base region through an opening at the auxiliary layer.

8. The semiconductor structure according to any one of claims 1 to 7, wherein the semiconductor structure further comprises an inner side wall; and
the inner side wall is disposed between the extrinsic base region and the emitter region.

9. The semiconductor structure according to any one of claims 1 to 8, wherein the semiconductor structure further comprises an emitter electrode, a base electrode, and a collector electrode disposed on the substrate; and
the emitter electrode is in contact with the emitter region, the base electrode is in contact with the extrinsic base region, and the collector electrode is in contact with the collector region.

10. The semiconductor structure according to claim 9, wherein the substrate further comprises a sinker region and a buried collector region, the sinker region and the first isolation structure are located above the buried collector region, the sinker region is located on a side that is of the first isolation structure and that is away from the collector region, and both the sinker region and the collector region are in contact with the buried collector region;
the collector electrode is in contact with the collector region through a connection hole that is in contact with the sinker region;
the emitter electrode is in contact with the emitter region through a connection hole that passes through a cap layer and is in contact with the emitter region; and
the base electrode is in contact with the extrinsic base region through a connection hole that is in contact with the extrinsic base region.

11. The semiconductor structure according to any one of claims 1 to 10, wherein the substrate further comprises a third isolation structure, and the third isolation structure is disposed outside the first isolation structure; and
the semiconductor structure further comprises a complementary metal-oxide-semiconductor field-effect transistor, and the complementary metal-oxide-semiconductor field-effect transistor is disposed on the substrate, and is located on a side that is of the third isolation structure and that is away from the first isolation structure.

12. A radio frequency circuit, comprising a transistor circuit that comprises the semiconductor structure according to any one of claims 1 to 11.

13. A communication apparatus, comprising a processor and the radio frequency circuit according to claim 12, wherein the processor is configured to transmit a signal to the radio frequency circuit.

14. A preparation method for a semiconductor structure, comprising:
forming a groove on a base comprising an active region, wherein the groove is located under a to-be-formed extrinsic base region;
sequentially forming an isolation film and an auxiliary extrinsic base region film on the base on which the groove is formed, and patterning the isolation film and the auxiliary extrinsic base region film, to form a first isolation structure and an auxiliary extrinsic base region that are located in the groove, wherein the first isolation structure wraps a side surface and a bottom surface of the auxiliary extrinsic base region;
forming a first sacrificial film, a second sacrificial film, and an auxiliary film that are sequentially stacked on a surface of the base, and forming an emitter region window that passes through the auxiliary film and the second sacrificial film;
forming a collector region in the base, to form a substrate of the semiconductor structure, wherein the collector region is located under the emitter region window;
forming, on the first sacrificial film, an opening in communication with the emitter region window, and forming an intrinsic base region in the opening, wherein the intrinsic base region is in contact with the collector region on a surface of the substrate;
forming an emitter region film on the auxiliary film, and patterning the emitter region film and the auxiliary film, to form an emitter region and an auxiliary layer, wherein the emitter region is in contact with the intrinsic base region through the emitter region window; and
removing the first sacrificial film and the second sacrificial film, to form an extrinsic base region at a corresponding position, wherein the extrinsic base region is in contact with the auxiliary extrinsic base region on the surface of the substrate, and the extrinsic base region is further in contact with the intrinsic base region.

15. The preparation method for a semiconductor structure according to claim 14, wherein the forming a groove on a base comprising an active region comprises:
forming the groove in the active region.

16. The preparation method for a semiconductor structure according to claim 14, wherein the forming a groove on a base comprising an active region comprises:
forming the active region and a shallow trench isolation region on the base, wherein the shallow trench isolation region is located under the extrinsic base region; and
removing a part of the shallow trench isolation region and a part of the active region at a periphery of the shallow trench isolation region, to form the groove, and using the shallow trench isolation region, under the groove, that is not removed as a second isolation structure of the semiconductor structure.

17. The preparation method for a semiconductor structure according to any one of claims 14 to 16, wherein the preparation method further comprises:
forming a third isolation structure on the base, wherein the third isolation structure is located outside the first isolation structure; and forming a complementary metal-oxide-semiconductor field-effect transistor on the substrate, wherein the complementary metal-oxide-semiconductor field-effect transistor is located on a side that is of the third isolation structure and that is away from the first isolation structure.
